# EUROPEAN PATENT APPLICATION

(11) **EP 4 753 426 A1**
(43) Date of publication of application: **03.06.2026**
(21) Application number: 25218765.3
(22) Date of filing: 26.11.2025
(51) Int. Cl.: H10K 59/131, H10K 59/124, H10K 77/10

(54) **DISPLAY DEVICE**

(30) Priority: 27.11.2024 KR 20240172476
(71) Applicant: LG Display Co., Ltd., Seoul, 07336 (KR)
(72) Inventor: KIM, Nam Woo, 10845 Paju-si (KR); PAEK, Seung Han, 10845 Paju-si (KR); HYUN, Myeong Hak, 10845 Paju-si (KR); YOON, Kyung Jae, 10845 Paju-si (KR); HAN, Jeon Phill, 10845 Paju-si (KR)
(74) Representative: Ter Meer Steinmeister & Partner

(57) **Abstract**

A display device can include a first substrate including a plurality of subpixels, a second substrate disposed on one side of the first substrate and including a pad portion, a bending portion that connects the first substrate and the second substrate, an etch stop layer disposed in the bending portion, a planarization layer disposed on the etch stop layer, a plurality of connection lines disposed on the planarization layer, and a first blocking pattern overlapping with at least one of the plurality of connection lines, the first blocking pattern being disposed between the etch stop layer and the planarization layer.

## Description

This application claims priority to and the benefit of Korean Patent Application No. 10-2024-0172476, filed in the Republic of Korea on November 27, 2024.

### BACKGROUND

### 1. Field of the Invention

The present specification relates to a display device, and more specifically, to a display device capable of preventing damage to configurations provided in a bending portion.

### 2. Discussion of Related Art

The field of display devices that can visually display electrical information signals is rapidly developing as we enter the full-fledged information age. Accordingly, research for developing performance such as thinning, weight reduction, and low power consumption for various display devices is continuing.

Specific examples of display devices can include a liquid crystal display device (LCD), an organic light-emitting display device (OLED), a quantum dot display device, and the like.

Display devices are being designed in various ways to reduce an area of a non-display region, where images are not displayed, for the aesthetic appeal for users. Among them, research is being conducted to fold or bend various portions of display devices using flexible materials.

However, the manufacture of such flexible regions for a display device often involves complex processes, such as patterning and selective removal of various material layers to achieve the desired pliability and electrical functionality. Also, the flexible region can often include sensitive electronic components that are susceptible to damage. During manufacturing, these delicate structures can be exposed to various processing agents or environmental conditions that may compromise their integrity.

In addition, during the life of the device, the stress of bending and flexing can lead to the formation of micro-cracks or delamination between layers. This degradation can impair electrical performance and ultimately lead to device failure.

Thus, a need exists for an improved device architecture that enhances the durability and protects the vulnerable components within the flexible portions of display devices from damage that may occur during manufacturing and use of the device.

### SUMMARY OF THE INVENTION

An etching process of removing a substrate can be performed in a bending portion of a display device to reduce stress applied to the substrate during bending. A line disposed in the bending portion can expand due to fumes or gas generated from an etchant in the etching process, and as a result, problems such as reduced reliability, a short circuit, and the like can occur. Accordingly, there is a need to provide a display device capable of blocking fumes of the etchant directed toward a line.

There is a need to provide a display device capable of preventing damage to components provided in a bending portion which is a bent region of the display device.

There is a need to provide a display device capable of minimizing cracks due to stress at joining surfaces between first and second substrates and an etch stop layer on the first and second substrates during bending.

The objects according to embodiments of the present specification are not limited to the above-described objects, and other objects that are not mentioned will be clearly understood by those skilled in the art from the following description.

At least one of these objects is solved by the features of the independent claim. Further embodiments are specified in the dependent claims.

A display device according to an aspect of the present specification includes a first substrate including a plurality of subpixels, a second substrate disposed to face the first substrate and including a pad portion, a bending portion that connects the first substrate and the second substrate, an etch stop layer disposed in the bending portion, a planarization layer disposed on the etch stop layer, a plurality of connection lines disposed on the planarization layer, and a first blocking pattern overlapping with the plurality of connection lines and disposed between the etch stop layer and the planarization layer.

A display device according to another aspect of the present specification includes a first substrate including a plurality of subpixels; a second substrate disposed on one side of the first substrate with a coating layer between the first substrate and the second substrate, the second substrate including a pad portion; a plurality of insulating layers disposed on the coating layer; a plurality of connection lines disposed between the plurality of insulating layers; and at least one layer of a blocking pattern overlapping with the plurality of connection lines and disposed between the coating layer and the plurality of connection lines, wherein at least one layer of the plurality of insulating layers includes a trench disposed in a region between the plurality of connection lines.

The display device according to at least one aspect of the present specification may further include at least one of the following features:

At least one of the etch stop layer and the planarization layer may include a first trench disposed in a region between the plurality of connection lines.

The display device may comprise a bank disposed on the planarization layer. The bank may include a second trench disposed in a region between the plurality of connection lines. The first trench and the second trench may overlap with each other.

The first blocking pattern may include a metal. The etch stop layer may include an organic insulating material.

The display device may comprise a coating layer disposed between the first substrate and the second substrate. The coating layer may overlap with a portion of the etch stop layer. The display device may further comprise a second blocking pattern disposed between the etch stop layer and the coating layer. The second blocking pattern may be disposed in a region between the plurality of connection lines.

The display device may comprise a first electrode corresponding at least one of the plurality of subpixels. The plurality of connection lines may be disposed on a same layer as the first electrode.

The display device may comprise at least one transistor disposed on the first substrate. The at least one transistor may correspond to the first electrode. The display device may further comprise a first connection electrode that electrically connects the first electrode with a drain electrode of the at least one transistor. The first blocking pattern may be disposed on a same layer as the first connection electrode.

The display device may comprise a first pad layer disposed on a same layer as a source electrode or the drain electrode of the at least one transistor. The first pad layer may be electrically connected to at least one of the plurality of connection lines. The second blocking pattern may be disposed on the same layer as the first pad layer.

The display device may comprise a coating layer disposed between the first substrate and the second substrate. The coating layer may overlap with a portion of the etch stop layer. The coating layer may include a first surface in contact with each of the first and second substrates. The coating layer may include a second surface that is opposite to the first surface. The second surface may be formed at an angle with respect to the first surface. The second surface of the coating layer may be bent or curved from a surface where a flat upper surface of each of the first and second substrates and the etch stop layer are in contact with each other. The second surface of the coating layer may be bent or curved from a surface plane in which a flat upper surface of the first substrate and the second substrate are each in contact with the etch stop layer.

The coating layer may include a convex portion protruding in a direction toward the etch stop layer.

The first blocking pattern may include a first layer adjacent to the first and second substrates. The first blocking pattern may include a plurality of layers on the first layer. The first layer of the first blocking pattern may have higher chemical resistance to an etchant than the plurality of layers.

The plurality of connection lines may include a first layer adjacent to the first and second substrates. The plurality of connection lines may include a plurality of layers on the first layer. The first layer of the plurality of connection lines may have higher chemical resistance to an etchant than the plurality of layers

The at least one layer of the blocking pattern may include a first blocking pattern. The first blocking pattern may include a metal.

The plurality of insulating layers may include an etch stop layer disposed between the first blocking pattern and the coating layer. The plurality of insulating layers may include a planarization layer disposed between the first blocking pattern and at least one of the plurality of connections lines.

The trench may include a first trench in at least one of the etch stop layer and the planarization layer.

The plurality of insulating layers may further include a bank disposed on the planarization layer. The bank may include a second trench disposed in a region between the plurality of connection lines. The first trench and the second trench may overlap with each other.

The at least one layer of the blocking pattern may include a second blocking pattern between the first blocking pattern and the coating layer.

The display device may include at least one transistor disposed on the first substrate. The at least one transistor may correspond to a first electrode of at least one of the plurality of subpixels. The display device may include a first connection electrode that electrically connects the first electrode with a drain electrode of the at least one transistor. The first blocking pattern may be disposed on a same layer as the first connection electrode.

The display device may comprise a first pad layer disposed on a same layer as a source electrode or the drain electrode of the at least one transistor. The first pad layer may be electrically connected to one of the plurality of connection lines.

The coating layer may include a first surface in contact with each of the first and second substrates. The coating layer may include a second surface that may be bent from the first surface. The second surface may be adjacent to the etch stop layer. The second surface of the coating layer may bent from a surface where a flat upper surface of each of the first and second substrates and the etch stop layer are in contact with each other.

The coating layer may include a convex portion protruding from the second surface to the etch stop layer.

The at least one layer of the blocking pattern may include a first layer adjacent to the first and second substrates. The at least one layer of the blocking pattern may include a plurality of layers on the first layer. The first layer of the first blocking pattern may have higher chemical resistance to an etchant than the plurality of layers.

The plurality of connection lines may include a first layer adjacent to the first and second substrates. The plurality of connection lines may include a plurality of layers on the first layer. The first layer of the connection line may have higher chemical resistance to an etchant than the plurality of layers.

### BRIEF DESCRIPTION OF THE DRAWINGS

The following drawings attached to this specification illustrate preferred embodiments of the present invention and, together with the detailed description of the invention to be described below, serve to further understand the technical idea of the present invention. The drawings are briefly described below.
FIG. 1 is a schematic diagram of a display device according to an embodiment of the present specification.
FIG. 2 is an enlarged plan view of region A in FIG. 1 according to an embodiment of the present specification.
FIG. 3 is a cross-sectional view taken along line I-I' in FIG. 2 according to an embodiment of the present specification.
FIG. 4 is a cross-sectional view taken along line II-II' in FIG. 2 according to an embodiment of the present specification.
FIG. 5 is a cross-sectional view showing a modified example of FIG. 3 according to an embodiment of the present specification.
FIGs. 6A and 6B is a view showing material structures of a connection line and a first blocking pattern of the display device according to an embodiment of the present specification.
FIG. 7 is an enlarged plan view of region A in FIG. 1 according to another embodiment of the present specification.
FIG. 8 is a cross-sectional view taken along line III-III' in FIG. 7 according to an embodiment of the present specification.
FIG. 9 is an enlarged plan view of region A in FIG. 1 according to another embodiment of the present specification.
FIG. 10 is a cross-sectional view taken along line IV-IV' in FIG. 9 according to an embodiment of the present specification.
FIG. 11A is a cross-sectional view showing a modified example of FIG. 10 according to an embodiment of the present specification.
FIG. 11B is a cross-sectional view showing a portion of an etching process for the structure of FIG. 11A according to an embodiment of the present specification.
FIG. 12 is an enlarged plan view of region A in FIG. 1 according to another embodiment of the present specification.
FIG. 13 is a cross-sectional view taken along line V-V' in FIG. 12 according to an embodiment of the present specification.
FIG. 14A is a cross-sectional view showing a modified example of FIG. 13 according to an embodiment of the present specification.
FIG. 14B is a cross-sectional view showing a portion of an etching process for the structure of FIG. 14A according to an embodiment of the present specification.
FIG. 15 is an enlarged plan view of region A in FIG. 1 according to another embodiment of the present specification.
FIG. 16 is a cross-sectional view taken along line VI-VI' in FIG. 15 according to an embodiment of the present specification.
FIG. 17 is a cross-sectional view taken along line VII-VII' in FIG. 15 according to an embodiment of the present specification.
FIG. 18A is a cross-sectional view of a bending portion according to another embodiment of the present specification.
FIG. 18B is a cross-sectional view of region C in FIG. 1 according to an embodiment of the present specification.
FIGs. 19A to 19D are process diagrams according to an embodiment of the present specification.
FIG. 20 is a schematic cross-sectional view showing a bending state of a display panel according to an embodiment of the present specification.

### DETAILED DESCRIPTION OF THE EMBODIMENTS

Advantages and features of the present specification and a method of achieving the same should become clear with embodiments described in detail below with reference to the accompanying drawings. The embodiments are merely provided to allow those skilled in the art to completely understand the scope of the present specification.

The shapes, dimensions, ratios, angles, numbers, and the like disclosed in the drawings for describing the embodiments of the present specification are merely illustrative. Like reference numerals refer to like elements throughout the specification. Further, in describing the present specification, detailed descriptions of well-known technologies will be omitted when it is determined that they can unnecessarily obscure the gist of the present specification. Terms such as "including," "having," and "composed of" used herein are intended to allow other elements to be added unless the terms are used with the term "only." Any references to the singular can include the plural unless expressly stated otherwise.

Components are interpreted as including an ordinary error range even if no such margin is explicitly stated.

In the situation of a description of a positional relationship, for example, in the situation in which a position relationship between two portions is described with the terms "on," "above," "under," "next to," or the like, one or more portions can be interposed therebetween unless the term, for example, "right," "directly," or "near" is used in the expression.

For the description of a temporal relationship, when a temporal relationship is described as "after," "subsequently to," "next," "before," and the like, a non-consecutive situation can be included unless the term "immediately" or "directly" is used in the expression.

Although the terms "first," "second," and the like can be used herein to describe various components, the components are not limited by the terms. These terms are used only to distinguish one component from another. Therefore, a first component described below can be a second component within the technological scope of the present specification.

Terms such as first, second, A, B, (a), (b), or the like can be used herein when describing components of the present specification. Such terms are used only to distinguish a component from another component, but do not limit the nature, sequence, order, number, or the like of components.

It is to be understood that when a component is described as being "connected," "coupled," "linked," or "attached" to another component, the component can be directly connected, coupled, linked, or attached to the other component, but, unless specifically stated otherwise, still another component can be interposed between these two components so that they are indirectly connected, coupled, linked, or attached.

It is also to be understood that when a component or layer is described as being "in contact with" or "overlapping" another component or layer, the component or layer can be in direct contact with or directly overlapping the other component or layer, but, unless specifically stated otherwise, still another component or layer can be interposed between these two components or layers so that they are in indirect contact with or indirectly overlapping each other.

The term "at least one" should be understood as including any and all combinations of one or more of the associated listed components. For example, the meaning of "at least one of a first component, a second component, and a third component" denotes the combination of all components proposed from two or more of the first component, the second component, and the third component as well as the first component, the second component, or the third component.

The terms "first direction," "second direction," "third direction," "X-axis direction," "Y-axis direction," and "Z-axis direction" should not be interpreted as referring only to geometrical relationships that are perpendicular to each other, but can indicate a broader range of directions within the functional scope of the configuration described in the present specification.

The features of various embodiments of the present specification can be partially or entirely combined with each other. The embodiments can be technically linked and operate in various ways and can be carried out independently of or in association with each other. Also, the term "can" used herein includes all meanings and definitions of the term "may."

Hereinafter, various embodiments of the present specification will be described in detail with reference to the accompanying drawings.

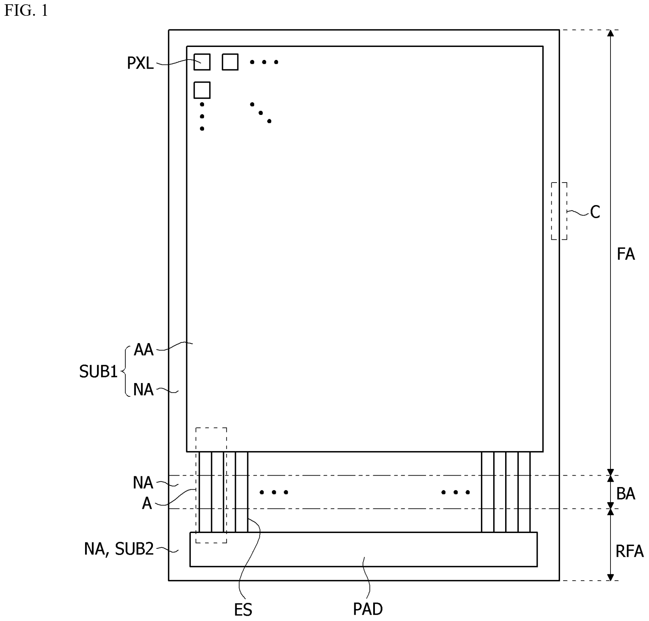

FIG. 1 is a schematic diagram of a display device according to one embodiment of the present specification.

Referring to FIG. 1, the display device of the present specification can include a first substrate SUB1 and a second substrate SUB2 spaced apart from each other with a bending portion BA therebetween in a flat state which is a state before bending. The first substate SUB1 may include a first substrate area, the second substrate SUB2 may include a second substrate area. For example, a flexible display device may include the first substrate area and the second substrate area. The first substrate SUB1 can include a plurality of subpixels PXL, and the second substrate SUB2 can include a pad portion PAD.

The first substrate SUB1 can be divided into a display region AA where an image is displayed and a non-display region NA where the image is not displayed, and the plurality of subpixels PXL can be repeatedly disposed in the first substrate SUB1.

The plurality of subpixels PXL can be defined by gate lines and data lines intersecting each other and formed in a matrix form on the substrate SUB1. Each of the plurality of subpixels PXLs can be formed of a light-emitting portion which is a region where light is actually emitted, and a non-light-emitting portion which is a region around the light-emitting region where light is not emitted.

The second substrate SUB2 can be classified as a non-display region NA and can include the pad portion PAD. On the second substrate SUB2, various lines and driving circuits can be disposed, and the pad portion PAD to which an integrated circuit, a printed circuit, and the like are connected can be disposed.

The pad portion PAD can be electrically connected to a connection line ES connected from the first substrate SUB1. Further, the pad portion PAD can be connected to a flexible printed circuit board FPCB outside the second substrate SUB2. However, the display device of the present specification is not limited thereto.

The display panel of the present specification can be manufactured based on a glass substrate. The first and second substrates SUB1 and SUB2 can be formed of an insulating material or a flexible material, but the present specification is not limited thereto. For example, the first and second substrates SUB1 and SUB2 can be made of glass, metal, plastic, or the like. For example, a glass substrate having certain strength can be used as the first and second substrates SUB 1 and SUB2. Since the first and second substrates SUB1 and SUB2 are made of glass substrates and various etching patterns can be simultaneously formed through a mask, a process can be simplified.

The bending portion BA can be disposed between the first substrate SUB1 and the second substrate SUB2. The first substrate SUB1 and the second substrate SUB2 can be disposed on both sides of the bending portion BA with respect to a bending direction. An edge of the bending portion BA can partially overlap with each of the first substrate SUB1 and the second substrate SUB2. Accordingly, the first substrate SUB1 can include a front surface portion FA of a region not overlapping with the bending portion BA. The second substrate SUB2 can include a rear surface portion RFA of the region not overlapping with the bending portion BA.

The second substrate SUB2 can be disposed on one side of the first substrate SUB1 and can be connected to the first substrate SUB1 by the bending portion BA. The rear surface portion RFA can be disposed on one side of the front surface portion FA and can be connected to the front surface portion FA by the bending portion BA.

As the panel is bent, since the front surface portion FA and the rear surface portion RFA can overlap with each other, the first substrate SUB1 and the second substrate SUB2 can be disposed to face each other with the bending portion BA therebetween. However, the present specification is not limited thereto. For example, as the panel is bent, the front surface portion FA and the rear surface portion RFA may not face each other, and the first substrate SUB1 and the second substrate SUB2 can be disposed so as not to face each other with the bending portion BA therebetween.

A plurality of connection lines ES can be disposed in the bending portion BA. The plurality of connection lines ES can be configured to transmit signals from the pad portion PAD of the second substrate SUB2 to the plurality of subpixels PXL of the first substrate SUB1. In the drawing, each connection line ES is shown as being in a straight line form in the bending direction of the bending portion BA, but the present specification is not limited thereto. For example, the plurality of connection lines ES can be formed in a form in which a portion of the straight line is bent or in a diagonal line form in the bending direction of the bending portion BA.

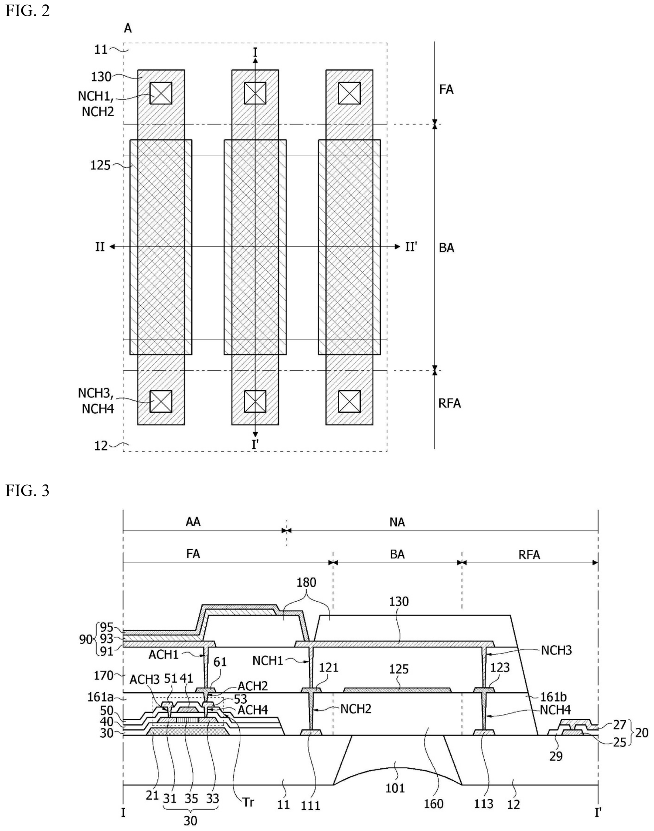

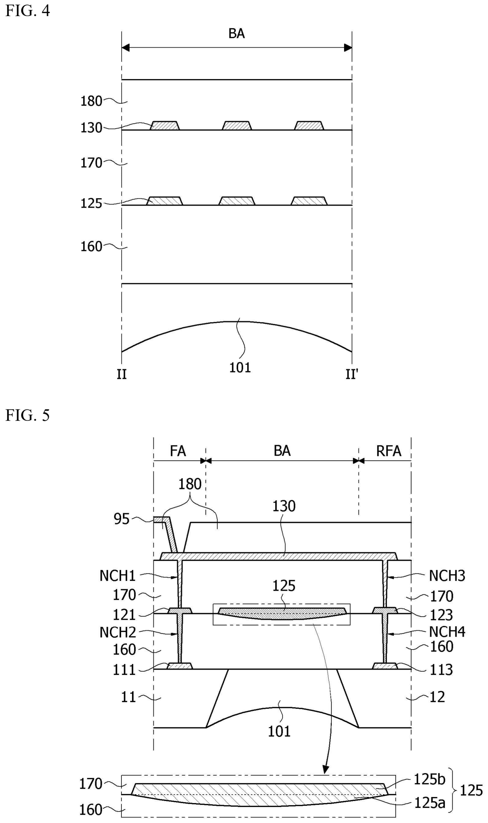

FIG. 2 is an enlarged plan view of region A in FIG. 1 according to a first embodiment of the present specification. FIG. 3 is a cross-sectional view taken along line I-I' in FIG. 2, and FIG. 4 is a cross-sectional view taken along line II-II' in FIG. 2.

A display device according to one embodiment includes a first substrate 11 including a plurality of subpixels PXL, a second substrate 12 disposed on one side of the first substrate 11 or facing the first substrate 11, and including a pad portion 20, a bending portion BA which connects the first substrate 11 and the second substrate 12, an etch stop layer 160 disposed on the bending portion BA, a planarization layer (e.g., an upper planarization layer, 170) disposed on the etch stop layer 160, a plurality of connection lines 130 disposed on the planarization layer (e.g., an upper planarization layer 170), and a first blocking pattern 125 overlapping with the plurality of connection lines 130 and disposed between the etch stop layer 160 and the planarization layer 170.

Referring to FIG. 2, the display device according to the first embodiment can be disposed so that each first blocking pattern 125 overlaps with at least one connection line 130. Referring to FIG. 4 together, the first blocking pattern 125 can be disposed to correspond one to one to the connection line 130. The first blocking pattern 125 can overlap with the connection lines 130 in a region excluding at least contact holes NCH1, NCH2, NCH3, and NCH4 of the connection line 130. For example, the first blocking pattern 125 does not overlap with the contact holes NCH1, NCH2, NCH3, and NCH4, and thus can be formed shorter than a length of the connection line 130 in the bending direction and wider than a width of the connection line 130. For example, the first blocking pattern 125 may be spaced apart from a corresponding contact hole by a certain distance. For example, the one or more first blocking patterns SD may be disposed between the first and the second contact holes NCH1 and NCH2 on the first substrate and the third and the fourth contact holes NCH3 and NCH4 on the second substrate SUB2.

Referring to FIG. 3, in the present specification, an example of an organic light-emitting diode (OLED) display device among various types of display devices is described. However, the present specification is not limited thereto.

Referring to FIG. 3, a display region AA can include a light-emitting element 90 provided in each of the plurality of subpixels PXL on the first substrate 11 and at least one transistor Tr which drives the light-emitting element 90. On the first substrate 11, various signal lines such as data signal lines and gate signal lines and circuit elements including transistors such as switching thin film transistors and driving thin film transistors, capacitors, and the like can be formed for each subpixel. In the present specification, one arbitrary transistor Tr which drives one light-emitting element 90 is shown for the convenience of description, and the display device of the present specification can include the at least one transistor Tr and/or more transistors, etc.

The at least one transistor Tr can include an active layer 30, a gate electrode 41 overlapping with a channel region 35 of the active layer 30 with a gate insulating film interposed therebetween, and a source electrode 51 and a drain electrode 53 respectively connected to a source region 31 and a drain region 33 on both sides of the active layer 30.

The active layer 30 of the transistor Tr can have the source region 31 and the drain region 33 on both sides with the channel region 35 therebetween. Each of the source region 31 and the drain region 33 can be formed of a semiconductor material into which n-type or p-type impurities are injected. The channel region 35 overlapping with the gate electrode 41 can be formed of a semiconductor material into which n-type or p-type impurities are not injected.

The gate electrode 41 of the transistor Tr can overlap with the channel region 35 of the active layer 30 with the same width with the gate insulating film therebetween. For example, the gate electrode 41 can be a single layer or multiple layers made of any one or more of molybdenum (Mo), aluminum (Al), chromium (Cr), gold (Au), titanium (Ti), nickel (Ni), neodymium (Nd), and copper (Cu), and an alloy thereof. Meanwhile, the gate insulating film can be made of an inorganic insulating material, for example, a silicon oxide film (SiOx), a silicon nitride film (SiNx), a silicon oxynitride film (SiOxNy), or a multilayer film thereof.

Meanwhile, a light blocking layer 21 on the first substrate 11 can overlap with at least the channel region 35 of the active layer 30 of the transistor Tr, and can be disposed under the active layer 30. The light blocking layer 21 can prevent external light from passing through the first substrate 11 and being transmitted to the transistor Tr. For example, the light blocking layer 21 can be made of a single layer of a metal material such as molybdenum (Mo), titanium (Ti), aluminum-neodymium (AINd), aluminum (Al), chromium (Cr), or an alloy thereof, or can be formed in a multilayer structure using the same.

A buffer film 30 on the light blocking layer 21 can cover the light blocking layer 21. For example, the buffer film 30 can be formed in a single layer structure or multilayer structure of silicon oxide (SiOx) and/or silicon nitride (SiNx).

An interlayer insulating film 40 on the buffer film 30 can include a source contact hole ACH3 and a drain contact hole ACH4 which respectively expose the source region 31 and the drain region 33 of the active layer 30, and can cover the gate electrode 41. For example, the interlayer insulating film 40 can be made of an inorganic insulating material. Also, the interlayer insulating film 40 can be made of a single layer or multiple layers of a silicon oxide film (SiOx), a silicon nitride film (SiNx), and/or a silicon oxynitride film (SiOxNy).

The source electrode 51 and the drain electrode 53 can be provided on the same layer on the interlayer insulating film 40. The source electrode 51 and the drain electrode 53 are respectively connected to the source region 31 and the drain region 33 of the active layer 30 through the source contact hole ACH3 and the drain contact hole ACH4. For example, the source electrode 51 and the drain electrode 53 can be made of a single layer of a metal material such as molybdenum (Mo), aluminum (Al), chromium (Cr), gold (Au), titanium (Ti), nickel (Ni), neodymium (Nd), copper (Cu), or an alloy thereof, or can be formed in a multilayer structure using the same.

A passivation layer 50 on the interlayer insulating film 40 can cover the transistor Tr. Accordingly, the transistor Tr can be protected by the passivation layer 50. When the first lower planarization layer 161a also functions to protect the transistor Tr, the passivation layer 50 can be omitted. For example, the passivation layer 50 is a type of inorganic insulating film and can be made of a single layer or multiple layers of a silicon oxide film (SiOx), a silicon nitride film (SiNx), and/or a silicon oxynitride film (SiOxNx).

At least one planarization layer can be disposed on the passivation layer 50. The at least one planarization layer can include one or two or more planarization layers. The display device according to one embodiment of the present specification can include a first lower planarization layer 161a, an etch stop layer 160, and a second lower planarization layer 161b as at least one planarization layer.

The first lower planarization layer 161a, the etch stop layer 160, and the second lower planarization layer 161b can be formed with the same mask and can be provided as the same layer. The first lower planarization layer 161a, the etch stop layer 160, and the second lower planarization layer 161b can be formed with a thickness which can sufficiently planarize a surface step of an upper portion of the transistor Tr, and can be formed of an organic insulating film. However, the present specification is not limited thereto. For example, the first lower planarization layer 161a, the etch stop layer 160, and the second lower planarization layer 161b are a type of organic insulating film, and can be made of any one of photo acryl, polyimide, a benzocyclobutene series resin, and the acrylate series, and in some situations, can be formed of multiple layers.

An upper planarization layer 170 can be disposed on the first and second lower planarization layers 161a and 161b and the etch stop layer 160. The upper planarization layer 170 can be provided over the first substrate 11, the bending portion BA, and the second substrate 12. That is, the upper planarization layer 170 can cover first to third connection electrodes 61, 121, and 123 and the first blocking pattern 125. The upper planarization layer 170 is a type of organic insulating film, and can be made of any one of photo acryl, polyimide, a benzocyclobutene series resin, the acrylate series, and the like.

A first connection electrode 61 can be provided between the first lower planarization layer 161a and the upper planarization layer 170. The first connection electrode 61 can be an electrode which connects the at least one transistor Tr and a first electrode 91. For example, the first electrode 91 can be in contact with the first connection electrode 61 through a first contact hole ACH1, and the first connection electrode 61 can be in contact with the at least one transistor Tr through a second contact hole ACH2. However, the display device of the present specification is not limited thereto. For example, two or more planarization layers can be provided between the first electrode 91 and the at least one transistor Tr, and thus a plurality of connection electrodes which connect the first electrode 91 and the at least one transistor Tr can be provided.

For example, the first connection electrode 61 can be made of a single layer of a metal material such as molybdenum (Mo), aluminum (Al), chromium (Cr), gold (Au), titanium (Ti), nickel (Ni), neodymium (Nd), copper (Cu) or an alloy thereof, or can be formed in a multilayer structure using the same.

The light-emitting element 90 including a stacked structure of the first electrode 91, an intermediate layer 93, and a second electrode 95 can be provided on the upper planarization layer 170. When current supplied from a power voltage line flows to the second electrode 95 and a high-voltage current is supplied to the first electrode 91 from the transistor Tr, the light-emitting element 90 can be driven as light is emitted from the intermediate layer 93 while an electric field is formed between the first electrode 91 and the second electrode 95. A light-emitting portion which is a region where light is emitted from the light-emitting element 90 can be a region exposed from a bank 180, but the display device of the present specification is not limited thereto, and the light-emitting portion can include a side surface and an upper surface of the bank 180 which can be provided with the intermediate layer 93.

The first electrode 91 can be provided in each of the plurality of subpixels PXL and can be electrically connected to each of the transistors Tr. When the display device of the present specification is a top emission type, the first electrode 91 can be formed to have higher reflection efficiency than the second electrode 95 to reflect light generated from the intermediate layer 93.

For example, the first electrode 91 can be formed in a multilayer structure including a transparent conductive film and an opaque conductive film with high reflection efficiency. The transparent conductive film of the first electrode 91 can be made of a material having a relatively high work function value such as indium tin oxide (ITO) or indium zinc oxide (IZO), and the opaque conductive film can be made of a single layer or multiple layers of any one or more selected from the group consisting of silver (Ag), aluminum (Al), copper (Cu), molybdenum (Mo), titanium (Ti), nickel (Ni), chromium (Cr), and tungsten (W) and an alloy thereof. For example, the first electrode 91 can be formed in a structure in which a transparent conductive film, an opaque conductive film, and a transparent conductive film are sequentially stacked, or in a structure in which a transparent conductive film and an opaque conductive film are sequentially stacked.

The intermediate layer 93 on the first electrode 91 can be provided over the entire display region AA of the first substrate 11. The intermediate layer 93 can be provided on the first electrode 91 opened by the bank 180, and a side surface and an upper surface of the bank 180. However, the present specification is not limited thereto.

The intermediate layer 93 can also mean a single stack of organic layers formed of multiple layers including a hole injection layer HIL, a hole transport layer HTL, an emission layer EML, an electron transport layer ETL, and an electron injection layer EIL. In some situations, the intermediate layer 93 can have a tandem structure including multiple stacks (a first stack and a second stack) each including an emission layer and a charge generation layer CGL between the stacks. Further, the tandem structure of the intermediate layer 93 is not limited to a two-stack structure, and can be formed of a plurality of stacks such as three or more stacks.

The second electrode 95 on the intermediate layer 93 can be entirely disposed in the display region AA to face the first electrode 91(e.g., intermediate layer 93 can be laid across multiple subpixels as a common layer). In some situations, the second electrode 95 can also be disposed in the non-display region NA to be in contact with a circuit portion in the non-display region NA. Referring to FIG. 3, the second electrode 95 can be in contact with the connection line 130 through an opening of the bank 180 in the non-display region NA.

When the display device of the present specification is a top emission type, the second electrode 95 can be made of a conductive layer of a transparent material. For example, the second electrode 95 can be made of a transparent conductive material such as indium tin oxide (ITO) or indium zinc oxide (IZO).

Meanwhile, the bank 180 can cover an edge of the first electrode 91 and can be disposed on the upper planarization layer 170. The bank 180 can include an opening which exposes the first electrode 91 to a region for emission of the light-emitting element 90 and an opening or a contact hole which exposes the connection line 130 to a region for contact with the connection line 130. For example, the bank 180 can be made of an organic material such as a polyimide, acrylate, a benzocyclobutene series resin, or the like.

Also, the display device according to one embodiment of the present specification can further include an encapsulation layer on the bank 180. The encapsulation layer can be formed of a plurality of layers. For example, the encapsulation layer can be formed in a structure in which inorganic films and organic films are alternately stacked. The inorganic film can be composed of a metal oxide, a metal nitride, a metal carbide, and a compound thereof. For example, the inorganic film can include inorganic materials such as AlOx, TiO2, ZrO, SiOx, AlON, AIN, SiNx, SiOxNy, InOx, YbOx, and the like. The organic film can include a polymer-based material. The polymer-based material can include an acrylic resin, an epoxy resin, a silicone resin, an allyl resin, polyimide, and polyethylene.

The bending portion BA can be included in the non-display region NA. The bending portion BA can be a region which is bent in the display device and can include a separation space between the first and second substrates 11 and 12 or more or less. In the present specification, the bending portion BA can include all of the separation space between the first and second substrates 11 and 12 in a flat state before bending. For example, the first and second substrates 11 and 12 can be spaced apart from each other with the bending portion BA therebetween. However, the display device of the present specification is not limited thereto.. For example, according to another embodiment, first and second substrates 11 and 12 can different areas of a same flexible substrate.

In one embodiment of the present specification, the bending portion BA can include a coating layer 101, the etch stop layer 160, the first blocking pattern 125, the upper planarization layer 170, the connection line 130, and the bank 180. In one embodiment of the present specification, the non-display region NA outside the bending portion BA, that is, adjacent to the bending portion BA, can include a first pad layer 111, the first lower planarization layer 161a, a second connection electrode 121, the upper planarization layer 170, the bank 180, the connection line 130, the first contact hole NCH1 and the second contact hole NCH2 on the first substrate 11, and can include a second pad layer 113, the second lower planarization layer 161b, a third connection electrode 123, the upper planarization layer 170, the bank 180, the connection line 130, the third contact hole NCH3, and the fourth contact hole NCH4 on the second substrate 12. For example, a conductive bridge structure can be formed over and around sides of the first blocking pattern 125. However, the display device of the present specification is not limited thereto.

The first pad layer 111 and the second pad layer 113 can be disposed in a region adjacent to the bending portion BA. The first pad layer 111 can be disposed on the first substrate 11, and the second pad layer 113 can be disposed on the second substrate 12. Specifically, the first pad layer 111 can be disposed between the first substrate 11 and the first lower planarization layer 161a, and the second pad layer 113 can be disposed between the second substrate 12 and the second lower planarization layer 161b.

The first and second pad layers 111 and 113 can be electrically connected through the connection line 130. The second pad layer 113 can be electrically connected to the pad portion 20. Accordingly, the first and second pad layers 111 and 113 can transmit signals or voltages from an external module bonded to the pad portion 20 to the display region AA or a circuit portion such as a gate driver.

The pad portion 20 can be disposed on one side of the non-display region NA. However, in the display device of the present specification, the shape and arrangement of the pad portion 20 is not limited to those shown. The pad portion 20 can be a metal pattern to which external modules, for example, a flexible printed circuit board FPCB, a chip on film COF, and the like are bonded.

The pad portion 20 can include a signal pad 25 and a pad electrode 27 connected to the signal pad 25. The signal pad 25 can be formed in the same process as the source and drain electrodes 51 and 53 of the transistor Tr. Accordingly, the signal pad 25 can be made of the same material as the source and drain electrodes 51 and 53, but the display device of the present specification is not limited thereto. The pad electrode 27 can be formed in the same process as the first connection electrode 61. Accordingly, the pad electrode 27 can be made of the same material as the first connection electrode 61, but the display device of the present specification is not limited thereto.

The second connection electrode 121 and the third connection electrode 123 can be disposed on the same layer as the first connection electrode 61. The second connection electrode 121 can be disposed on the first lower planarization layer 161a of the first substrate 11 adjacent to the bending portion BA, and the third connection electrode 123 can be disposed on the second lower planarization layer 161b of the second substrate 12 adjacent to the bending portion BA. The second connection electrode 121 and the third connection electrode 123 can electrically connect the connection line 130 to the first and second pad layers 111 and 113, respectively.

The connection line 130 can be disposed from the first substrate 11 to the bending portion BA and the second substrate 12. The connection line 130 can be in contact with the second connection electrode 121 through the first contact hole NCH1 on one side. The second connection electrode 121 can be in contact with the first pad layer 111 through the second contact hole NCH2. Accordingly, the connection line 130 and the first pad layer 111 can be electrically connected to each other on the first substrate 11 through the second connection electrode 121.

The connection line 130 can be in contact with the third connection electrode 123 through the third contact hole NCH3 on the other side. The third connection electrode 123 can be in contact with the second pad layer 113 through the fourth contact hole NCH4. Accordingly, the connection line 130 and the second pad layer 113 can be electrically connected to each other on the second substrate 12.

However, the display device of the present specification is not limited thereto, the second and third connection electrodes 121 and 123 may be omitted, and the connection line 130 can be in direct contact with the first and second pad layers 111 and 113.

The coating layer 101 can be disposed in the bending portion BA between the first and second substrates 11 and 12. The coating layer 101 can be disposed to prevent cracks and short circuits of various lines located in the bending portion BA. Further, the coating layer 101 can also include physical and chemical protection functions capable of protecting the various lines disposed on the flexible substrate from an external impact, moisture, or dust during the manufacturing process. For example, the coating layer 101 can be a micro coating layer (MCL). Also, the coating layer 101 can be deposited in a hole or depression in the first substrate 11 and/or second substrate 12 which extends partially into the substrate or all the way through the substrate, but embodiments are not limited thereto. The coating layer 101 can be thinner than the first substrate 11, but embodiments are not limited thereto.

The etch stop layer 160 can be disposed on the coating layer 101. The etch stop layer 160 can be provided to prevent the etching of components on the substrate in the etching process of the substrate. The etch stop layer 160 can include a material having chemical resistance to an etchant (e.g., a glass etching fluid (GEF)). For example, the etch stop layer 160 can be formed in the same process as the first and second lower planarization layers 161a and 161b, and can be formed of a type of organic insulating film. Accordingly, even when an etchant etches the substrate of the bending portion BA and thus the etch stop layer 160 is exposed, the etch stop layer 160 of the organic film can prevent direct penetration of the etchant into the panel. Meanwhile, fumes which penetrate the etch stop layer 160 can be blocked by a structure such as the first blocking pattern 125.

The first blocking pattern 125 can be provided on the etch stop layer 160. The first blocking pattern 125 can overlap with at least the bending portion BA. Further, the first blocking pattern 125 can overlap with at least the connection line 130. Referring to FIG. 4, a plurality of first blocking patterns 125 according to the first embodiment can be spaced apart from each other and respectively overlap with the connection lines 130. Also, a width of the first blocking pattern 125 can be greater than or equal to a width of the connection line 130, but embodiments are not limited thereto.

The first blocking pattern 125 can be formed in the same layer as the first to third connection electrodes 61, 121, and 123. For example, the first blocking pattern 125 can be disposed between the second and third connection electrodes 121 and 123 connected to one connection line 130. The connection line 130 can be electrically connected to another electrode, while the first blocking pattern 125 may not be connected to an electrode or a line.

As an example, when a line having an electrical connection is disposed on an upper surface of the etch stop layer 160, a short circuit between adjacent electrodes on the left and right can occur by the line expanding due to the fumes generated when etching the substrate. Accordingly, the display device of the present specification can effectively prevent corrosion and deformation of the connection line 130 due to fumes by providing the first blocking pattern 125 between the etch stop layer 160 and the connection line 130 having an electrical connection.

The shape, thickness, and the like of the first blocking pattern 125, can be determined depending on the etching process time (e.g., that is, the etching amount) of the substrate.

The first blocking pattern 125 can include a different material from the etch stop layer 160. The first blocking pattern 125 can include a metal. In some situations, in the first blocking pattern 125, a surface in contact with the etch stop layer 160 can be made of a metal oxide by a reaction due to fumes (or ions).

For example, the etchant can be a GEF. A mixed acid material of hydrogen fluoride (HF) or nitric acid (HNO3) can be used as the etchant. As a result of a reaction by the fluoride (F) component of the fumes during exposure to fumes for a certain period of time or more, the metal component (for example, Al or Ti) of the first blocking pattern 125 can diffuse to a partial region of the first blocking pattern 125 in contact with the etch stop layer 160. Accordingly, a lower side of the first blocking pattern 125 can be made of a metal oxide film containing the F component while an oxygen (O) component increases. In other words, the lower surface of the first blocking pattern 125 can have a protective patina-like film formed from the reaction with the fumes (e.g., a thin passivating oxidation layer that can include some fluoride and oxygen).

Meanwhile, the F component, which can be the main cause of metal corrosion, can be hardly found in the upper planarization layer 170. That is, since the fumes are prevented from penetrating into the upper planarization layer 170 and the connection line 130 by the first blocking pattern 125, deformation, expansion, and corrosion of the connection line 130 used as a line can be prevented.

Referring to FIG. 5, the first blocking pattern 125 can include a first layer 125a and a second layer 125b. The first blocking pattern 125 can include the first layer 125a located under the upper surface of the etch stop layer 160 and the second layer 125b located above the upper surface of the etch stop layer 160 with the upper surface of the etch stop layer 160 (e.g., a surface where the etch stop layer 160 and the upper planarization layer 170 are in contact with each other) as a boundary.

As shown in FIG. 5, in the first blocking pattern 125, a surface of the first layer 125a in contact with the etch stop layer 160 and a surface of the second layer 125b in contact with the upper planarization layer 170 can be formed in different shapes. For example, the surface of the first blocking pattern 125 in contact with the etch stop layer 160 can be formed in a curved shape, and the surface of the second layer 125b in contact with the upper planarization layer 170 can be formed to be flat, but the present specification is not limited thereto. For example, the first blocking pattern 125 can have a curved bottom surface and a flat top surface when the display device is not in the bended state. Also, when the display device is in the bended state, a lower surface of the coating layer can have a smaller radius of curvature than an upper surface of the coating layer.

The first blocking pattern 125 can have sufficient time for the metal components of fumes to react as an etching amount of the substrate increases, that is, as the substrate is exposed to the fumes for a long time. As a result, the first layer 125a of the first blocking pattern 125 can have a greater thickness as the etching amount of the substrate increases. Further, the first layer 125a of the first blocking pattern 125 can contain a larger amount of O (oxygen) components as the first layer 125a is exposed to the fumes for a longer time than the second layer 125b. For example, the first layer 125a of the first blocking pattern 125 can have a higher oxygen content than the second layer 125b of the first blocking pattern 125.

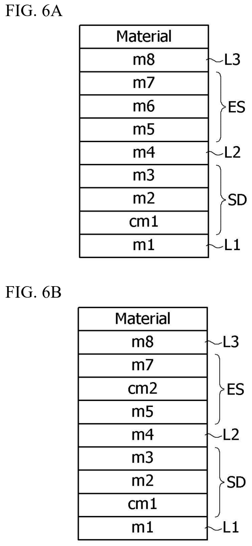

The first blocking pattern 125 can include a multilayer structure. Referring to FIG. 6A, the material structure of each layer disposed in the bending portion BA can include, in order from the bottom, an etch stop layer L1 (160 in FIG. 3), a first blocking pattern SD (125 in FIG. 3), an upper planarization layer L2 (170 in FIG. 3), a connection line ES (130 in FIG. 3), and a bank L3 (180 in FIG. 3). The etch stop layer L1 can include a first material layer m1. The first blocking pattern SD (125 in FIG. 3) can include a first functional layer cm1, a second material layer m2, and a third material layer m3. The upper planarization layer L2 can include a fourth material layer m4. The connection line ES can include a fifth material layer m5, a sixth material layer m6, and a seventh material layer m7. The bank L3 can include an eighth material layer m8. The first functional layer cm1 closest to the substrate among the multilayer structures cm1, m2, and m3 of the first blocking pattern SD can include a specific material due to the characteristics of the etchant that etches the substrate.

The first functional layer cm1 of the first blocking pattern SD can include a material which can have a blocking effect on fumes generated from the etchant. Further, the first functional layer cm1 may include a material having higher chemical resistance to the etchant than the other layer of the first blocking pattern SD. Accordingly, the first blocking pattern SD can minimize changes due to the fumes (or ions). For example, a change in thickness of the first layer 125a of the first blocking pattern 125 in FIG. 5 can be minimized by disposing the first functional layer cm1

Since the etchant for the glass substrate includes a mixed acid solution of hydrogen fluoride (HF) or nitric acid (HNO3), the first functional layer cm1 can include a material having high chemical resistance to fumes or ions generated from the etchant. For example, the first functional layer cm1 can include any one of Mo, Cr, p-Si, and ITO. For another example, the first functional layer cm1 can include Mo or Cr as a corrosion resistant metal. Further, considering that the first blocking pattern SD is disposed in the bending portion BA, the first blocking pattern SD can be formed with a minimum thickness for minimizing cracks and can be made of a flexible material.

The layer closest to the first substrate 11 in the connection line 130 can include a specific material due to the characteristics of the etchant which etches the substrate.

Referring to FIG. 6B, the material structure of each layer disposed in the bending portion BA can include, in order from the bottom, the etch stop layer L1, the first blocking pattern SD, the upper planarization layer L2, the connection line ES, and the bank L3. The etch stop layer L1 can include a first material layer m1. The first blocking pattern SD can include a first functional layer cm1, a second material layer m2, and a third material layer m3. The upper planarization layer L2 can include a fourth material layer m4. The connection line ES can include a fifth material layer m5, a second functional layer cm2, and a seventh material layer m7. The bank L3 can include an eighth material layer m8.

The second functional layer cm2 closest to the substrate among the multilayer structure cm2, m5, and m7 of the connection line ES can include a specific material due to the characteristics of the etchant that etches the substrate. Accordingly, corrosion and deformation due to the fumes can be secondarily prevented by disposing the second functional layer cm2 in the connection line ES.

The second functional layer cm2 of the connection line ES can be formed in the same process as the first electrode 91. For example, the second functional layer cm2 can include any one of silver (Ag), aluminum (Al), copper (Cu), molybdenum (Mo), titanium (Ti), nickel (Ni), chromium (Cr), and tungsten (W).

For example, since the etchant includes a mixed acid solution of hydrogen fluoride (HF) or nitric acid (HNO3), the second functional layer cm2 of the connection line ES may include a material with higher chemical resistance to fumes or ions generated from the etchant than the other layers of the connection line ES. For example, the second functional layer cm2 can be made of molybdenum (Mo) having excellent resistance to the fumes. Considering that the connection line ES is disposed in the bending portion BA, the connection line ES can be formed with a minimum thickness for minimizing cracks, and can be made of a flexible material.

FIG. 6A shows that only the first blocking pattern SD has the functional layer cm1, or FIG. 6B shows that the first blocking pattern SD and the connection line ES each have the functional layers cm1 and cm2, but the present disclosure is not limited thereto. For example, the functional layer can be provided only in the connection line ES, or can be provided in the second blocking pattern included in the following embodiments.

Hereinafter, other embodiments to be implemented can include all of the structures of the first and second layers 125a and 125b of the first blocking pattern 125 in FIGS. 5 and 6, and can include all of the multilayer structures of the first blocking pattern SD and the multilayer structures of the connection line ES based on FIGS. 6A and 6B, and can also have effects thereof.

The material structures of the bending portion BA as shown in FIGS. 6A and 6B may correspond to and/or may be implemented in any of the first to the sixth embodiments of the present specification and modified examples thereof.

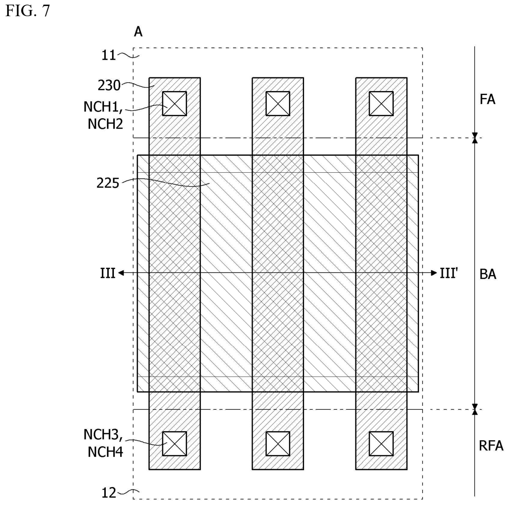

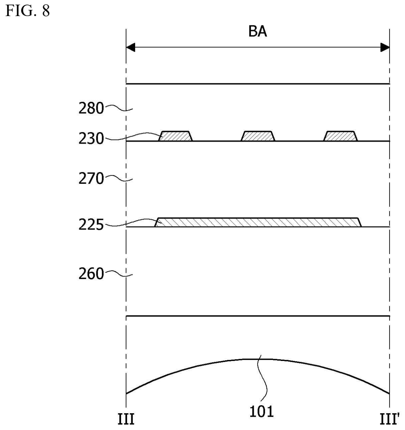

FIG. 7 is an enlarged plan view of region A in FIG. 1 according to a second embodiment of the present specification, and FIG. 8 is a cross-sectional view taken along line III-III' in FIG. 7. Hereinafter, the description of the same configuration as the first embodiment will be omitted.

Referring to FIGS. 7 and 8, a display device according to the second embodiment of the present specification can include one first blocking pattern 225 overlapping with a plurality of connection lines 230. For example, one first blocking pattern 225 can overlap with two or three or more connection lines 230, or can overlap with all of the plurality of connection lines 230. The display device according to the second embodiment of the present specification will be described with an example in which one first blocking pattern 225 overlaps with three connection lines 230.

Referring to FIG. 7, the connection lines 130 shown in FIG. 5 are in contact with the connection electrodes (e.g., 121 and 123 in FIG. 3) and are also in contact with the first and second pad layers (e.g., 111 and 113 in FIG. 3), and in the same manner, the connection line 230 shown in FIG. 7 can be in contact with the connection electrodes (e.g., 121 and 123 in FIG. 3) and can also be in contact with the first and second pad layers (e.g., 111 and 113 in FIG. 3).

The first blocking pattern 225 can be disposed at least between first and second contact holes NCH1 and NCH2 and third and fourth contact holes NCH3 and NCH4 in a bending portion BA. The first blocking pattern 225 can overlap with the connection lines 230 in a region excluding at least the first to fourth contact holes NCH1, NCH2, NCH3, and NCH4. Overlapping can mean overlapping in thickness, length, vertical and width directions. Accordingly, the display device of the present specification can effectively prevent corrosion and deformation due to fumes as well as prevent etching of the connection line 230 by disposing the first blocking pattern 225 between the etch stop layer 260 and the connection line 230 having an electrical connection.

Display devices according to third to fifth embodiments of the present specification and modified examples thereof to be implemented below can include an insulating layer on upper portions of each of a coating layer, a first blocking pattern, and connection lines, and the plurality of insulating layers can include trenches corresponding to regions between the connection lines in at least one layer.

The display device according to one embodiment of the present specification can include a trench in at least one of an etch stop layer, an upper planarization layer 270, and a bank 280. The display device of the present specification is not limited to the above-described structures of the trenches, and the various structures of the trenches described in the present specification can be applied to all embodiments of the present specification.

For example, the trenches can be formed only in the etch stop layer, formed to be continuous in the etch stop layer and the upper planarization layer, formed only in the upper planarization layer, formed to be continuous in the upper planarization layer and the bank, or formed only in the bank. Alternatively, the trenches can be formed in all of the etch stop layer, the upper planarization layer, and the bank, and the trenches can overlap with each other. However, the trench of the present specification can be provided to correspond to a region between the plurality of connection lines ES. Further, since an effect of the trench can be maximized or a process can be simplified as an interaction between the first blocking pattern and the second blocking pattern occurs, the trench can be formed as shown in the embodiment implemented below in consideration thereof.

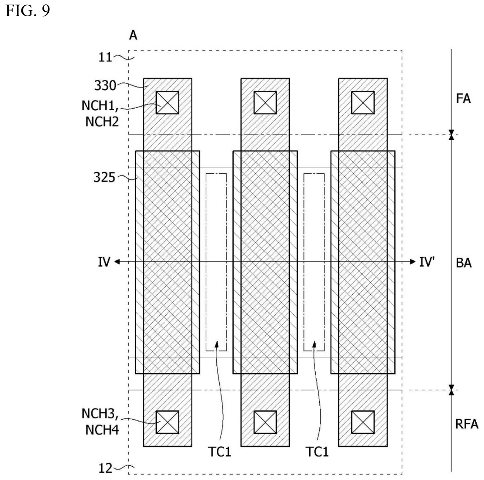

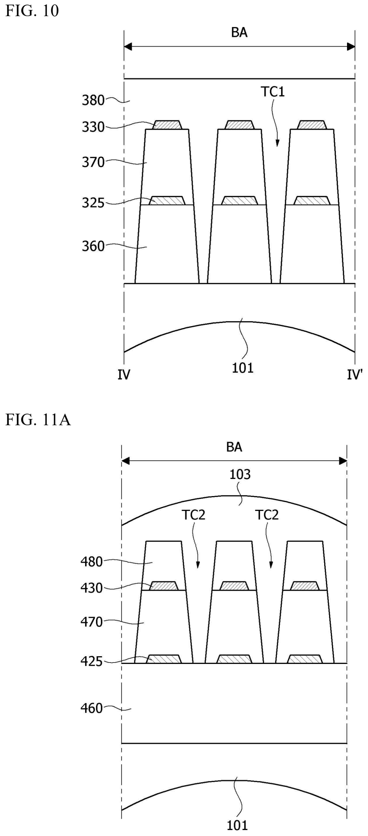

FIG. 9 is an enlarged plan view of region A in FIG. 1 according to the third embodiment of the present specification, and FIG. 10 is a cross-sectional view taken along line IV-IV' in FIG. 9.

Referring to FIGS. 9 and 10, the display device according to the third embodiment of the present specification can include one first blocking pattern 325 overlapping with a plurality of connection lines 330. The first blocking pattern 325 and the connection line 330 according to the third embodiment can be disposed to correspond one to one, but one first blocking pattern 325 can overlap with the plurality of connection lines 330. Further, the display device according to the third embodiment can further include a trench TC1 in an etch stop layer 360 and an upper planarization layer 370 as a separation space between the first blocking patterns 325.

Similar to the connection lines 130 previously described with reference to FIG. 5 and the connection lines 230 previously described with reference to FIG. 7, which are in contact with the connection electrodes (e.g., 121 and 123 in FIG. 3) and also in contact with the first and second pad layers (e.g., 111 and 113 in FIG. 3), the connection lines 330 shown in FIG. 9 can be in contact with the connection electrodes (e.g., 121 and 123 in FIG. 3) and can also be in contact with the first and second pad layers (e.g., 111 and 113 in FIG. 3).

The first blocking pattern 325 can be provided at least between first and second contact holes NCH1 and NCH2 and third and fourth contact holes NCH3 and NCH4 in a bending portion BA. The first blocking pattern 325 can overlap with the connection lines 330 in a region excluding at least the first to fourth contact holes NCH1, NCH2, NCH3, and NCH4. Accordingly, the display device of the present specification can effectively prevent corrosion and deformation due to fumes as well as prevent etching of the connection line 330 by providing a first blocking pattern 325 between the etch stop layer 360 and the connection line 330 having an electrical connection.

The etch stop layer 360 and the upper planarization layer 370 according to the third embodiment can include a trench TC1. The trench TC1 can be continuously provided in the etch stop layer 360 and the upper planarization layer 370. Specifically, the trench TC1 can be formed in such a way that a thickness of the upper planarization layer 370 is removed from an upper surface of the upper planarization layer 370, and subsequently, a thickness of the etch stop layer 360 is removed from an upper surface of the etch stop layer 360. For example, the trench TC1 can be wider at the top and narrower at the bottom near the coating layer 101.

The trench TC1 can be provided in a separation space between the first blocking patterns 325. Some of the fumes generated in a substrate etching process can flow into the trench TC1 in the separation space between the first blocking patterns 325. The fumes flowing into the trench TC1 can be discharged along a bank 380 in the trench TC1.

A side surface of the upper planarization layer 370 overlapping with the connection line 330 can form a boundary surface that is in contact with the bank 380 by the trench TC1. For example, the trench TC1 can create a vertical interface or slightly slanted interface between the upper planarization layer 370 and the bank 38 alongside the connection line 330, which can impede the lateral diffusion of corrosive fumes, effectively blocking them from reaching and damaging the connection line 330. Accordingly, the fumes flowing into the trench TC1 can have difficulty in progressing to a lower surface of the connection line 330 in contact with the upper planarization layer 370 due to the boundary surface between the upper planarization layer 370 and the bank 380. Accordingly, the display device according to the third embodiment can more effectively prevent the fumes from heading toward the connection line 330 by further including the trench TC1.

Meanwhile, the bank 380 which covers the connection line 330 can be provided to fill the trench TC1. As the trench TC1 exposes an upper surface of a first coating layer 101, a side surface of the etch stop layer 360, and a side surface of the upper planarization layer 370, the bank 380 can be in contact with the upper surface of the first coating layer 101, the side surface of the etch stop layer 360, and the side surface of the upper planarization layer 370.

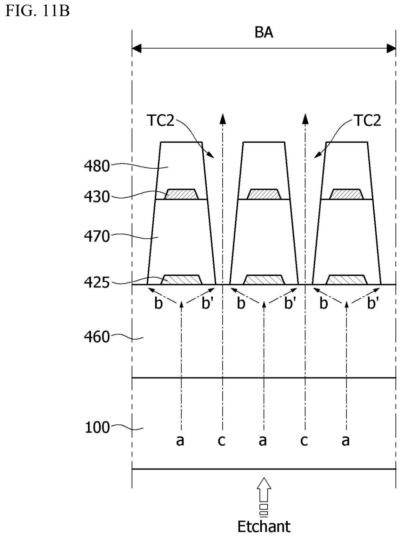

FIGS. 11A and 11B are cross-sectional views showing a modified example of FIG. 10. FIG. 11B is a cross-sectional view showing a portion of an etching process for the structure of FIG. 11A.

Referring to FIG. 11A, a trench TC2 according to the modified example of the third embodiment can be provided in a separation space between first blocking patterns 425, and can be formed in an upper planarization layer 470 and a bank 480. Compared to the previous embodiment, the trench TC2 can be formed in the bank 480 rather than in an etch stop layer 460. Accordingly, in the embodiment, a second coating layer 103 which fills the trench TC2 can be further included.

Since the trench TC2 is included in the bank 480, the second coating layer 103 which fills the trench TC2 can be further included. The second coating layer 103 can include the same material as the first coating layer 101 provided between the first and second substrates 11 and 12. The second coating layer 103, like the first coating layer 101, can also include physical and chemical protection functions capable of preventing cracks and short circuits of various lines located in the bending portion BA and protecting various lines from an external impact, moisture, or dust.

Further, the second coating layer 103 can be disposed on various lines such as a data line, a high-potential voltage line, a low-potential voltage line, and the like formed on the bending portion BA, and can adjust positions of the lines so that the lines become closer to a neutral line during bending. Accordingly, tensile stress formed above the neutral line and shrinkage stress formed under the neutral line can be applied to the lines as little as possible to enhance the durability of the lines. For example, by positioning the lines near this neutral plane, they are subjected to significantly less stretching (e.g., tensile stress) and compression (e.g., shrinkage stress), which can greatly improve the durability and reliability of the lines when the device is bent.

Referring to FIG. 11B together, the etching process of the substrate 100 can be performed before forming the first and second coating layers (101 and 103 in FIG. 9A). The etchant can be incident in a direction of the substrate 100. Fumes generated from the etchant can pass through the substrate 100 and the etch stop layer 460 and proceed in a first direction (a), second directions (b and b'), and a third direction (c). In the first direction (a) incident on a lower side of the first blocking pattern 425, some of the fumes can react with a lower surface of the first blocking pattern 425 to form the first layer (125a in FIG. 5), and some of the fumes can be dispersed in the second directions (b and b') on both sides of the first blocking pattern 425.

The fumes in the third direction (c) can proceed into the trench TC2 between the first blocking patterns 425. The fumes in the second directions (b and b') dispersed to both sides of the first blocking pattern 425 can proceed into the trench TC2. The display device of the present specification includes the trench TC2, and thus can discharge the fumes in the second and third directions (b, b', and c) not blocked by the first blocking pattern 425 to the trench TC2. In other words, the fumes can be routed away from and safely around the connection lines 430. Accordingly, the display device of the present specification can effectively prevent the fumes from damaging the connection line 430.

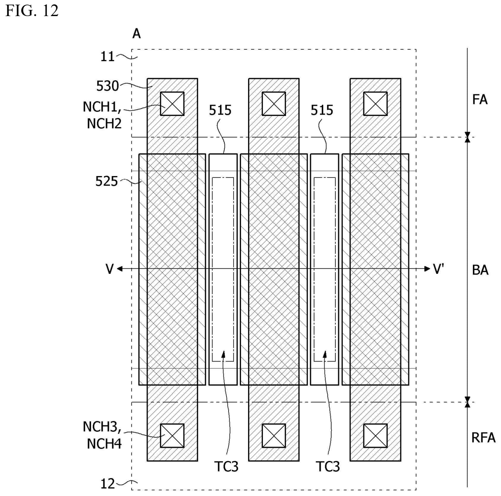

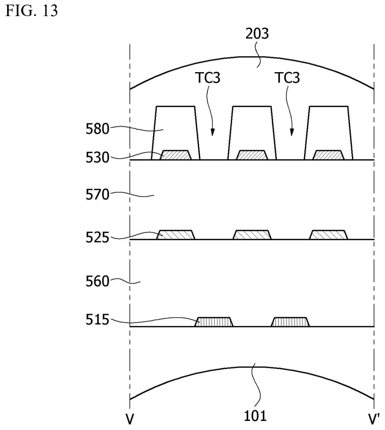

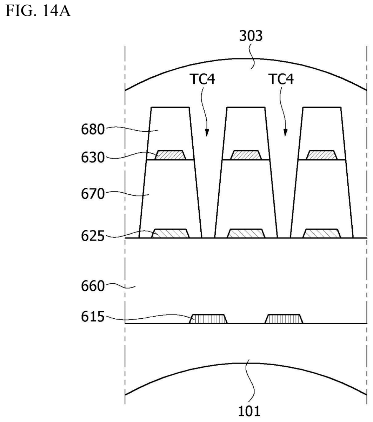

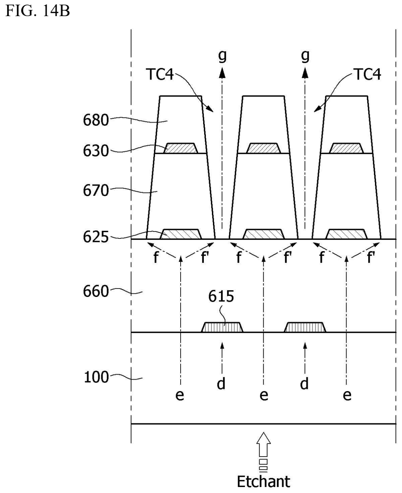

FIG. 12 is an enlarged plan view of region A in FIG. 1 according to a fourth embodiment of the present specification, and FIG. 13 is a cross-sectional view taken along line V - V' in FIG. 12. FIG. 14A is a cross-sectional view showing a modified example of FIG. 13, and FIG. 14B is a cross-sectional view showing a portion of an etching process for the structure of FIG. 14A.

Referring to FIGS. 12 and 13, according to the display device according to the fourth embodiment of the present specification, a first blocking pattern 525 and a connection line 530 can overlap with each other in at least a bending portion BA. In the embodiment, an example in which the first blocking pattern 525 and the connection line 530 correspond one to one is described.

In the fourth embodiment, a second blocking pattern 515 can be further included in the bending portion BA, e.g., under each trench TC3. The second blocking pattern 515 can be provided in a region between the connection lines 530. Further, when the connection line 530 and the first blocking pattern 525 overlap with each other, it can be seen that the second blocking pattern 515 is provided in a region between the first blocking patterns 525.

Referring to FIG. 12, it is shown that the first and second blocking patterns 525 and 515 are spaced apart from each other in a plan view, but the present specification is not necessarily limited thereto. For example, the first and second blocking patterns 525 and 515 can be disposed so that edges partially overlap or edge boundaries coincide with each other in a plan view.

The connection line 530 shown in FIGS. 12 and 13 can be in contact with the connection electrodes (e.g., 121 and 123 in FIG. 3) and the first and second pad layers (e.g., 111 and 113 in FIG. 3) in a manner the same as or similar to the above-described connection lines 130, 230, 330, and 430.

The first blocking pattern 525 can be disposed at least between first and second contact holes NCH1 and NCH2 and third and fourth contact holes NCH3 and NCH4 in the bending portion BA. The first blocking pattern 525 can overlap with the connection line 530 in a region excluding at least the first through fourth contact holes NCH1, NCH2, NCH3, and NCH4. Accordingly, the display device of the present specification can effectively prevent corrosion and deformation due to fumes as well as prevent etching of the connection line 530 by disposing the first blocking pattern 525 between the etch stop layer 560 and the connection line 530 having an electrical connection.

The second blocking pattern 515 can be disposed in a region not overlapping with the first blocking pattern 525 in the bending portion BA. The second blocking pattern 515 can be disposed on a first coating layer 101. The second blocking pattern 515 can be disposed on the same layer and formed in the same process as the first and second pad layers (111 and 113 in FIG. 3). Since the second blocking pattern 515 is disposed in a region not overlapping the connection line 530, the fumes can be physically blocked from penetrating into the region between the connection lines 530.

By disposing the first and second blocking patterns 525 and 515 in both the region overlapping with the connection line 530 and the region not overlapping with the connection line 530, the fumes can be effectively blocked from reaching the connection line 530. Accordingly, the display device according to the embodiment of the present specification can effectively prevent etching, corrosion, and deformation of the connection line 530. Further, since the first and second blocking patterns 525 and 515 are alternately disposed in the region overlapping with the connection line 530 and the region not overlapping with the connection line 530 in different layers, it can be effective in terms of increasing flexibility compared to when the blocking pattern is disposed as one continuous pattern in one layer. For example, by arranging the first blocking patterns 525 and the second blocking patterns 515 in a staggered, multi-layered configuration, they can create a robust barrier. This arrangement, with patterns located both overlapping and between the connection lines (530), can effectively block corrosive fumes and prevent damage. Also, because the blocking patterns are segmented and distributed across different layers instead of being one continuous sheet, the configuration can improve the flexibility of the bending portion.

Meanwhile, a bank 580 can include a trench TC3 in a separation space between the connection lines 530. As the display device of the present specification includes the trench TC3, since any of the fumes not blocked by the first and second blocking patterns 525 and 515 in the manufacturing process can be discharged through the trench TC3 (e.g., any remaining fumes can be guided away from and around connection lines 530), damage to the connection line 530 due to the fumes generated in the manufacturing process can be effectively prevented.

Since the trench TC3 is included in the bank 580, a second coating layer 203 which fills the trench TC3 can be further included. The second coating layer 203 can include the same material as the first coating layer 101 provided between the first and second substrates 11 and 12.

Referring to FIG. 14A, a trench TC4 according to the modified example of FIG. 13 can be disposed in a separation space between first blocking patterns 625 and can be formed in an upper planarization layer 670 and a bank 680. The trench TC4 can be continuously provided in the upper planarization layer 670 and the bank 680. For example, the trench TC4 can extend all the way through both of the upper planarization layer 670 and the bank 680, but embodiments are not limited thereto.

Referring to FIG. 14B together, the etching process of the substrate 100 may be performed before forming coating layers (101 and 303 in FIG. 14A). The etchant may be incident in a direction of the substrate 100. Fumes generated from the etchant may pass through the substrate 100 and an etch stop layer 660 and proceed in a first direction (d), second directions, a third direction (e), fourth directions (f and f), and a fifth direction (g). In the first direction (d) incident on a lower side of a second blocking pattern 615, some of the fumes may react with a lower surface of the second blocking pattern 615 to form the first layer (125a in FIG. 5). The second directions may correspond to the dispersion of some of the fumes to sides of the second blocking pattern 615.

In the third direction (e) incident on a lower side of the first blocking pattern 625, some of the fumes may react with a lower surface of the first blocking pattern 625 to form the first layer (125a in FIG. 5), and some of the fumes may be dispersed in the fourth direction (f and f) on both sides of the first blocking pattern 625.

The fumes in the fifth direction (g) can proceed into the trench TC4 between the first blocking patterns 625. The fumes in the fourth directions (f and f) dispersed to both sides of the first blocking pattern 625 can be proceed into the trench TC4. The display device of the present specification includes the trench TC4, and thus can discharge the fumes not blocked by the first and second blocking patterns 625 and 615 to the trench TC4. Accordingly, the display device of the present specification can effectively prevent the fumes from damaging the connection line 630.

Meanwhile, since the trench TC4 is included in the bank 680, a second coating layer 303 which fills the trench TC4 can be further included. The second coating layer 303 can include the same material as the first coating layer 101 provided between first and second substrates.

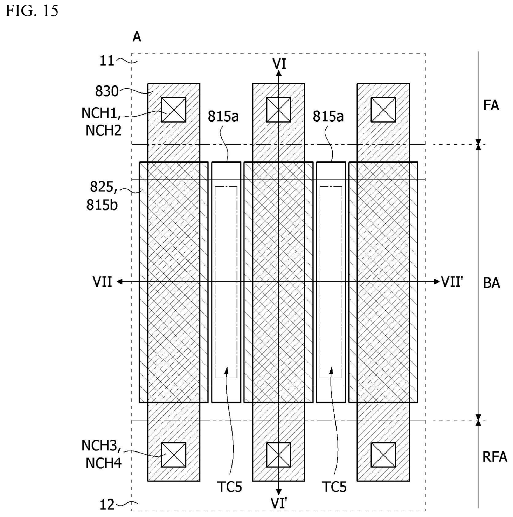

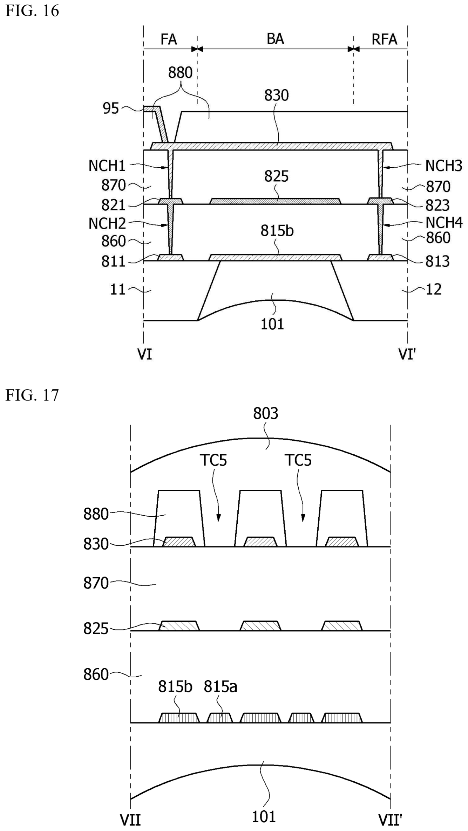

FIG. 15 is an enlarged plan view of region A in FIG. 1 according to a fifth embodiment of the present specification. FIG. 16 is a cross-sectional view taken along line VI-VI' in FIG. 15, and FIG. 17 is a cross-sectional view taken along line VII-VII' in FIG. 15.

Referring to FIGS. 15 to 17, according to the display device according to the fifth embodiment of the present specification, a first blocking pattern 825 and a connection line 830 can overlap with each other in at least a bending portion BA. In the embodiment, an example in which the first blocking pattern 825 and the connection line 830 correspond one to one is described. In the fifth embodiment, a second blocking pattern 815a and a third blocking pattern 815b can be further included in the bending portion BA.

The connection line 830 may be in contact with the connection electrodes 821 and 823 (corresponding to121 and 123 in FIG. 3) through first and third contact holes NCH1 and NCH3 provided in an upper planarization layer 870, and may be in contact with the first and second pad layers 811 and 813 (corresponding to 111 and 113 in FIG. 3) through second and fourth contact holes NCH2 and NCH4 provided in the first and second lower planarization layers (161a and 161b in FIG. 3) and the etch stop layer 860.

The first blocking pattern 825 can be provided at least between the first and second contact holes NCH1 and NCH2 and the third and fourth contact holes NCH3 and NCH4 in the bending portion BA. The first blocking pattern 825 can overlap with the connection line 830 in a region excluding at least the first through fourth contact holes NCH1, NCH2, NCH3, and NCH4.

The second and third blocking patterns 815a and 815b can be disposed on the first coating layer 101. The second and third blocking patterns 815a and 815b can be spaced apart from each other on the same layer. The second and third blocking patterns 815a and 815b can be disposed on the same layer as the first and second pad layers (111 and 113 in FIG. 3) and formed in the same process.

The second blocking pattern 815a can be disposed in a region between the connection lines 830. Further, when the connection line 830 and the first blocking pattern 825 overlap one to one, it can be seen that the second blocking pattern 815a is provided in a region between the first blocking patterns 825. Since the second blocking pattern 815a is disposed in a region not overlapping with the connection line 830, fumes can be physically blocked from penetrating into the region between the connection lines 830.

By disposing the second and third blocking patterns 815a and 815b in both the region overlapping the connection line 830 and the region not overlapping the connection line 830, the fumes may be effectively blocked from reaching the connection line 830 and the segmented configuration can further improve bending and flexibility. Accordingly, the display device according to the embodiment of the present specification may effectively prevent etching, corrosion, and deformation of the connection line 830. Further, since the second and third blocking patterns 815a and 815b are disposed spaced apart from each other, it can be effective in terms of increasing flexibility compared to when the second and third blocking patterns 815a and 815b are disposed as one pattern over the entire bending portion BA. In addition, in the embodiment, since the first blocking pattern 825 is disposed between the third blocking pattern 815a and the connection line 830, the fumes may be secondarily blocked by the first blocking pattern 825.

Meanwhile, the bank 880 can include a trench TC5 in a separation space between the connection lines 830. As the display device of the present specification includes the trench TC5, since any remaining fumes not blocked by the first to third blocking patterns 825, 815a, and 815b can be discharged to the trench TC5 in a direction away from and around The connection lines 830, damage to the connection line 830 by the fumes generated in the manufacturing process can be effectively prevented. In this way, multiple lines of defense can be provided for protecting the connection lines 830.

Since the trench TC5 is included in the bank 880, a second coating layer 203 which fills the trench TC5 can be further included. The second coating layer 803 can include the same material as the first coating layer 101 provided between the first and second substrates 11 and 12.

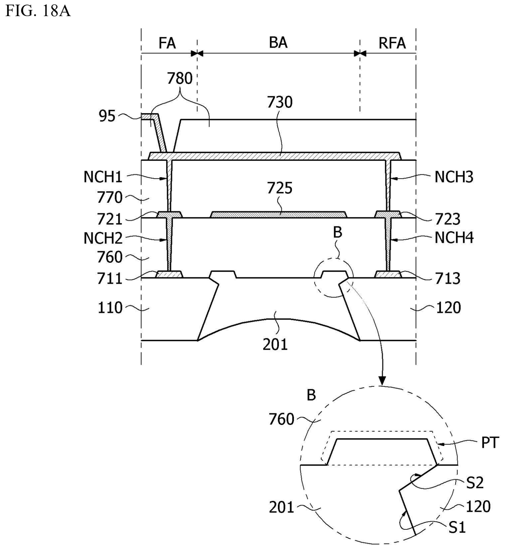

FIG. 18A is a cross-sectional view of a bending portion according to a sixth embodiment of the present specification.

Referring to FIG. 18A, a display device according to the sixth embodiment of the present specification can include a first coating layer 201 including a convex portion PT (e.g., a cut-out portion or notched area). Further, the first coating layer 201 according to the embodiment can include a first surface S1 and a second surface S2 in which the surfaces in contact with the first and second substrates 110 and 120 are bent.

The convex portion PT (e.g., a cut-out portion or notched area) of the first coating layer 201 can be formed on an upper portion of an edge of the first coating layer 201 in contact with each of the first and second substrates 110 and 120. In other words, the convex portion PT can be located at each corner where the first and second substrates 110 and 120 are in contact with an etch stop layer 760 and face each other.

Referring to region B in FIG. 18A, the convex portion PT of the first coating layer 201 can be formed in a form protruding toward the etch stop layer 760 from upper surfaces of the first and second substrates 110 and 120. In this way, multiple lines of defense can be provided for protecting the connection lines 830. In the drawings, the convex portion PT is shown as a trapezoidal shape, but the present specification is not limited thereto. For example, a cross-section of the convex portion PT can be formed in a semicircular shape, a rectangular shape, or a polygonal shape.

For each of the surfaces in contact with the first and second substrates 110 and 120, the first coating layer 201 can include the first and second surfaces S1 and S2. In the first coating layer 201, the first surface S1 can be connected to a lower surface of the first coating layer 201, and the second surface S2 can be bent from the first surface S1 and disposed adjacent to the etch stop layer 760.

The second surface S2 of the first coating layer 201 may be bent toward a center of the bending portion BA. The second surface S2 of the first coating layer 201 may be formed in a form which is bent from a surface where a flat upper surface of each of the first and second substrates 110 and 120 is in contact with the etch stop layer 760. Compared to the first and second surfaces S1 and S2 of the first coating layer 201 having a form which is bent once, the corner of the surface where the first coating layer 201 is in contact with each of the first and second substrates 110 and 120 may have a gentler shape. Accordingly, the display device of the present specification may prevent cracks from occurring at the corner where the first coating layer 201 is in contact with each of the first and second substrates 110 and 120 during bending. Further, in the display device of the present specification, the convex portion PT of the first coating layer 201 may be formed in a form surrounding the corner of each of the first and second substrates 110 and 120, thereby effectively preventing the cracks from occurring during the bending. For example, the first coating layer 201 can have a special convex shape or embossed (outwardly curved) shape where it meets the edges of the substrates (e.g., 110 and 120). This rounded or embossed design can wrap around the sharp corners to reduce stress concentration and effectively prevent cracks from forming when the device is bent.

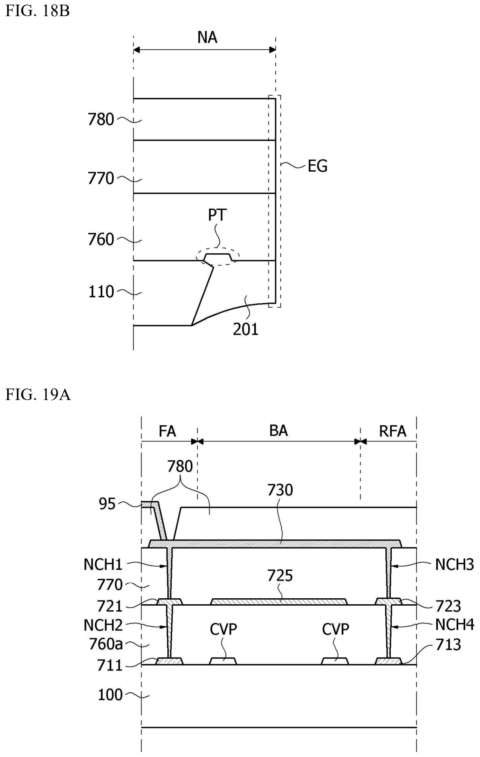

FIG. 18B is a cross-sectional view of region C in FIG. 1 according to the sixth embodiment of the present specification. The region C in FIG. 1 is a boundary portion EG which is an end of the non-display region NA of the first substrate 110.

Referring to FIG. 18B, in the display device according to the embodiment, the first substrate 110, the etch stop layer 760, an upper planarization layer 770, and a bank 780 can be sequentially disposed in the non-display region NA, and the first coating layer 201 can be disposed on the same layer as the first substrate 110.

The boundary portion EG is an end of a panel and can have a cut cross-section. The boundary portion EG can be located at an edge of a front surface portion FA of the first substrate 110 excluding the first substrate 110 in contact with the bending portion BA. Further, the boundary portion EG can be located at an edge of a rear surface portion RFA of the second substrate 120 excluding the second substrate 120 in contact with the bending portion BA. The boundary portion EG can be cut by a cutting member. For example, the cutting member can include a cutting wheel, a laser, or the like. However, the display device of the present specification is not limited thereto.

The first coating layer 201 of the non-display region NA can be spaced apart from the boundary portion EG and can include the convex portion PT in a direction of the display region AA. Accordingly, the convex portion PT of the first coating layer 201 can be formed along the boundary portion EG of the first and second substrates 110 and 120 in addition to the bending portion BA. In other words, the convex portion PT of the first coating layer 201 can be formed in a form surrounding each of the first substrate 110 and the second substrate 120. The convex portion PT included in the first coating layer 201 of the first substrate 110 can be formed in the same process as the convex portion PT included in the first coating layer 201 of the bending portion BA.

FIGS. 19A to 19D are process diagrams for the sixth embodiment.

Referring to FIG. 19A, the display device of the present specification can include a substrate 100, a first pad layer 711, a second pad layer 713, and a convex pattern CVP disposed on the substrate 100, a second connection electrode 721, a third connection electrode 723, and a first blocking pattern 725 disposed on a 1-1 etch stop layer 760a, a connection line 730 disposed on an upper planarization layer 770, and a bank 780 disposed on the connection line 730.

For example, the substrate 100 can be a glass substrate.

The convex pattern CVP can be disposed on the same layer as the first pad layer 711 and the second pad layer 713. The convex pattern CVP can be provided in an arbitrary region of the bending portion BA. Specifically, the convex pattern CVP can be disposed in the bending portion BA at a boundary surface between the bending portion BA and each of the front surface portion FA and the rear surface portion RFA.

The convex pattern CVP can be formed in a different process from the first and second pad layers 711 and 713 and can include a different material from the first and second pad layers 711 and 713. Alternatively, the convex pattern CVP can be formed in the same process as the first and second pad layers 711 and 713 and can include the same material as the first and second pad layers 711 and 713.

The convex pattern CVP can be etched together in a process of etching the substrate 100. The convex pattern CVP can include a material which can be etched by an etchant of the substrate 100. The convex pattern CVP can include an inorganic material or metal. For example, when the etchant is a mixed acid solution of hydrogen fluoride (HF) or nitric acid (HNO3), the convex pattern CVP can include an inorganic material or metal which can be etched by F.

For example, the convex pattern CVP made of an inorganic material can be formed in a different process from the first and second pad layers 711 and 713 and can be made of a silicon oxide film (SiOx), a silicon nitride film (SiNx), a silicon oxynitride film (SiOxNy), or a multilayer thereof.

For example, the convex pattern CVP made of a metal can be formed in the same process as the first and second pad layers 711 and 713 and can be made of a single layer of a metal material such as molybdenum (Mo), aluminum (Al), chromium (Cr), gold (Au), titanium (Ti), nickel (Ni), neodymium (Nd), copper (Cu), or an alloy thereof, or can be formed in a multilayer structure using the same. In this situation, the convex pattern CVP can be made of materials which can be easily etched by F such as Ti, Al, Cu, Ag, Ti/Al/Ti, MoTi/Cu/MoTi, MoTi/Cu, and Cu/MoTi. For example, when the convex pattern CVP is etched away, it can leave behind an empty space or notched area, which can be filled by a different material, such as the first coating layer 201.

For example, the convex pattern CVP made of a metal can be made of a single layer or multiple layers of any one selected from the group consisting of indium tin oxide (ITO), indium zinc oxide (IZO), silver (Ag), aluminum (Al), copper (Cu), molybdenum (Mo), titanium (Ti), nickel (Ni), chromium (Cr), and tungsten (W), or an alloy thereof.

For example, the convex pattern CVP can be made of materials which can be easily etched by F such as Cu/ITO and ITO/Ag/ITO.

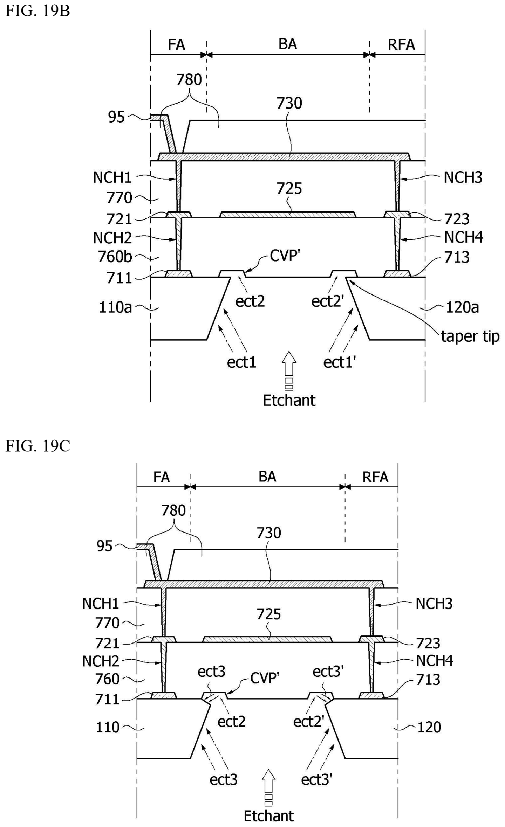

Next, referring to FIG. 19B, the etching process of the substrate 100 can be performed. In the present specification according to one embodiment, wet etching can be performed. The etchant is a solution containing F. and a mixed acid material of hydrogen fluoride (HF) or nitric acid (HNO3) can be used.

In addition, the etching process can be performed using a mask having an opening corresponding to the bending portion BA. The substrate 100 can be etched by spraying the etchant or in a deepening method while the mask is bonded.

Since the substrate 100 exposed to the etchant is etched, an opening can be formed in the substrate 100, and a depth of the opening can be deeper as the etching process time elapses. A tapered surface can be formed by controlling the etching process time (for example, the time the substrate 100 is exposed to the etchant).

As the etching process progresses, since the etchant penetrates between the substrate 100 and masks (ect1 and ect1' in FIG. 19B), tapered surfaces of sidewalls of a 1-1 substrate 110a and a 1-2 substrate 120a may be formed.

A 1-2 etch stop layer 760b can serve as an etch stopper in the etching process. As the etching process of the substrate 100 progresses, a lower surface of the 1-2 etch stop layer 760b can be exposed.

The convex pattern CVP can be etched together (ect2 and ect2' in FIG. 19B) in the etching process of the substrate 100. A groove CVP' of the etch stop layer 760 can be formed in a space where the convex pattern CVP is removed (e.g., an empty ring space can be formed around the upper edges of the etched hole).

Referring to FIG. 19C, since the etchant penetrates (e.g., ect3 and ect3' in FIG. 19C) between the groove CVP' and tapered tips (e.g., tapered tips in FIG. 19B) of the 1-1 and 1-2 substrates 110a and 120a while the etching process progresses even after the groove CVP' of the etch stop layer 760 is formed, bent side surfaces of the first and second substrates 110 and 120 can be formed.

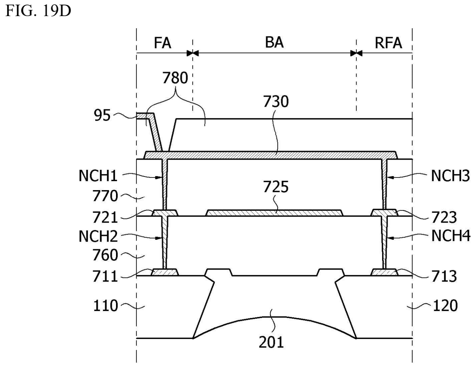

Referring to FIG. 19D, the substrate etching process can be completed and the first coating layer 201 can be formed between the first and second substrates 110 and 120 and the etch stop layer 760.

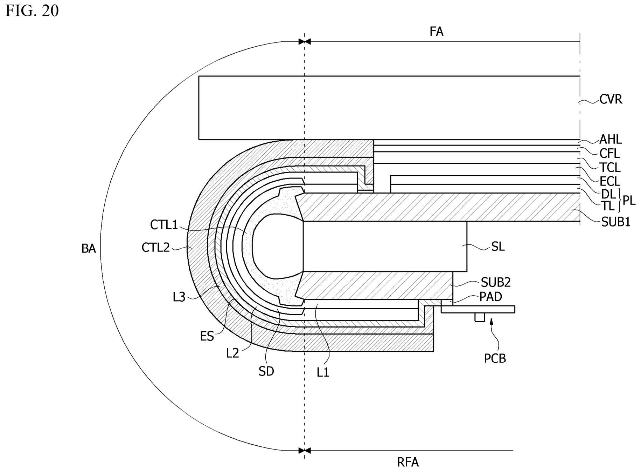

FIG. 20 is a schematic cross-sectional view showing a bending state of the display panel according to one embodiment of the present specification.

Referring to FIG. 20, a first substrate SUB1 and a second substrate SUB2 can be disposed to face each other with the bending portion BA therebetween.

The first substrate SUB1 and the second substrate SUB2 can respectively include a front surface portion FA and a rear surface portion RFA.

On the first substrate SUB1, a pixel array PL can be included in the display region, an encapsulation array ECL which covers the pixel array PL can be included, and a touch sensor array TCL, a color filter array CFL, and an adhesive layer AHL can be sequentially included on the encapsulation array ECL.

The pixel array PL can include a circuit layer TL disposed on the first substrate SUB1 and a light-emitting element layer DL disposed on the circuit layer TL.

The encapsulation array ECL can cover the light-emitting element layer DL to seal the light-emitting element layer DL. The encapsulation array ECL can have a multi-insulating film structure in which organic films and inorganic films are alternately stacked. The inorganic film can block the penetration of moisture or oxygen. The organic film can planarize a surface of the inorganic film. When the organic films and the inorganic films are stacked in multiple layers, since a movement path of moisture or oxygen becomes longer compared to a single layer, the penetration of moisture/ oxygen which affects the light-emitting element layer DL can be effectively blocked.

The touch sensor array TCL can include capacitive touch sensors which sense a touch input based on a change in capacitance before and after the touch input. The touch sensor array TCL can include metal line patterns and insulating films forming the capacitance of the touch sensors. The insulating films can insulate intersecting portions in the metal line patterns and planarize a surface of a touch sensor layer.

A polarization plate can be bonded to the touch sensor array TCL. The polarization plate can improve visibility and a contrast ratio by converting polarization of external light reflected by the metal patterns of the circuit layer TL. The polarization plate can be implemented as a polarization plate in which a linear polarization plate and a phase delay film are bonded or a circular polarization plate.

The color filter array CFL can be formed on the touch sensor array TCL. The color filter array CFL can include red, green, and blue color filters. Further, the color filter array CFL can further include a black matrix pattern. The color filter array CFL can replace the role of a polarization plate and increase color purity by absorbing some of wavelengths of light reflected from the circuit layer TL. A display panel in which the color filter array CFL is disposed can have enhanced light transmittance and improved thickness and flexibility by applying a color filter array CFL having higher light transmittance than the polarization plate to the display panel. The color filter array CFL can include an organic film which covers the color filter and the black matrix pattern. An extending portion of the organic film can cover an inorganic film residue or the first substrate SUB 1 in a bezel region of the display panel, that is, an edge region.

A cover glass CVR can be bonded to the color filter array CFL using the adhesive layer AHL.

In the bending portion BA, a first coating layer CTL1, an etch stop layer L1, a first blocking pattern SD, an upper planarization layer L2, a connection line ES, a bank L3, an encapsulation layer, and a second coating layer CTL2 can be sequentially disposed from the inside of the display device in a thickness direction.

In the bending portion BA, a second blocking pattern can be further disposed between the first blocking pattern SD and the first coating layer CTL1, and a trench can be further included in the upper planarization layer L2 and/or the bank L3.

Meanwhile, the encapsulation layer provided in the bending portion BA can be disposed on the same layer as at least one layer of the multilayer structure of the encapsulation array ECL provided in the display region on the first substrate SUB.

A pad portion PAD electrically connected to the connection line ES can be disposed on the second substrate SUB2, and a printed circuit board PCB can be disposed outside the second substrate SUB2. For example, the pad portion PAD may face the first substrate SUB1.

The printed circuit board PCB can transmit various signals to the connection line ES through the pad portion PAD. The printed circuit board PCB can be a flexible printed circuit board FBCB, but the present specification is not limited thereto.

The display panel according to the embodiment of the present specification can further include a functional member SL disposed between a lower surface of the first substrate SUB1 and a lower surface of the second substrate SUB2. The functional member SL can be disposed in contact between the first substrate SUB1 and the second substrate SUB2 to support the first substrate SUB1 and the second substrate SUB2. Accordingly, the functional member SL can serve as a support member to allow the first substrate SUB1 and the second substrate SUB2 to maintain a preset interval, e.g., providing dual functions of spacing and fixing support.

A display device according to one embodiment of the present specification can have an effect of preventing a connection line from being corroded and deformed by fumes generated during substrate etching.

The display device according to one embodiment of the present specification can have an effect of minimizing damage due to stress at joining surfaces between first and second substrates and an etch stop layer on the first and second substrates.

A display device according to an aspect of the present specification includes a plurality of subpixels disposed in a first substrate area, at least one pad disposed in a second substrate area, an etch stop layer disposed in a bending area between the first substrate area and the second substrate area, a plurality of connection lines disposed on the etch stop layer, at least one of the plurality of subpixels being electrically connected to the at least one pad via at least one of the plurality of connection lines, and a first blocking pattern disposed between the at least one of the plurality of connection lines and the etch stop layer.

According to the embodiment, a coating layer can be disposed between the first substrate area and the second substrate area, the coating layer overlapping with a portion of the etch stop layer, wherein a lower surface of the coating layer has a smaller radius of curvature than an upper surface of the coating layer.

According to the embodiment, the coating layer can include a convex portion disposed between the first substrate area and the second substrate area, the convex portion protruding towards the etch stop layer.

According to the embodiment, the display device further comprises at least one insulating layer disposed on the etch stop layer and at least one trench extending through the at least one insulating layer, wherein the at least one trench can be between two adjacent connection lines among the plurality of connection lines.

According to the embodiment, the display device further comprises a second pad layer disposed on the second substrate, wherein the first pad layer and the second pad layer can be electrically connected through the connection lines.

According to the embodiment, the display device further comprises a first lower planarization layer and a second lower planarization layer disposed on a same layer as the etch stop layer and a second connection electrode disposed on the first lower planarization layer and a third connection electrode disposed on the second lower planarization layer, wherein the first pad layer may be disposed between the first substrate and the first lower planarization layer, and the second pad layer may be disposed between the second substrate and the second lower planarization layer, and wherein the second connection electrode and the third connection electrode may electrically connect the connection lines to the first pad layer and the second pad layer, respectively.

According to the embodiment, the display device further comprises a third blocking pattern, wherein the second and third blocking pattern may be spaced apart from each other on the same layer, and wherein the first blocking pattern may be disposed between the third blocking pattern and the connection lines.

According to the embodiment, the convex portion may be disposed in a form surrounding a corner of each of the first and second substrates.

A display device according to an aspect of the present specification includes a first substrate including a plurality of subpixels, a second substrate disposed so as to face the first substrate, a functional member disposed between the first substrate and the second substrate, an etch stop layer disposed in a bending portion connecting the first substrate and the second substrate, a planarization layer disposed on the etch stop layer, a plurality of connection lines disposed on the planarization layer, one or more first blocking patterns overlapping with at least one of the plurality of connection lines.

According to the embodiment, the first blocking pattern can overlap the plurality of the connection lines and can space between the plurality of the connection lines.

According to the embodiment, the first and the second contact holes and can be disposed on the first substrate, and the third and the fourth contact holes and can be disposed on the second substrate.

According to the embodiment, the one or more first blocking patterns may be disposed between the first and the second contact holes and on the first substrate and the third and the fourth contact holes and on the second substrate.

According to the embodiment, one or more second blocking patterns can be disposed in spaces between the plurality of connection lines.

According to the embodiment, the third blocking pattern can be disposed between the second blocking patterns and overlapping with the first blocking patterns and the connection lines.

According to the embodiment, the trench can be disposed from planarization layer to the etch stop layer.

According to the embodiment, the trench can be disposed from the bank to the upper planarization layer.

According to the embodiment, the trench can be disposed in the bank.

According to the embodiment, the bending portion, a first coating layer, an etch stop layer, a first blocking pattern, an upper planarization layer, a connection line, a bank, an encapsulation layer, and a second coating layer can be sequentially disposed from the inside of the display device in a thickness direction.

According to the embodiment, a pad portion electrically connected to the connection line can be disposed on the second substrate, and a printed circuit board can be disposed outside the second substrate.

According to the embodiment, the pad portion may face the first substrate.

According to the embodiment, the encapsulation array can be disposed on the first substrate. The encapsulation array can have a multi-insulating film structure in which organic films and inorganic films are alternately stacked.

The effects according to the present specification are not limited to the above-mentioned effects, and other effects which are not mentioned can be clearly understood by those skilled in the art from the present specification.

The embodiments disclosed herein are to be considered descriptive.

Accordingly, the above-described embodiments should be understood to be exemplary.

## Claims

1. A display device comprising:
a first substrate (11, 110, SUB1) including a plurality of subpixels (PXL);
a second substrate (12, 120, SUB2) disposed on one side of the first substrate (11, 110, SUB1) and including a pad portion (PAD);
a bending portion (BA) that connects the first substrate (11, 110, SUB1) and the second substrate (12, 120, SUB2);
an etch stop layer (160, 260, 360, 460, 560, 660, 760, 860, L1) disposed in the bending portion (BA);
a planarization layer (170, 270, 370, 470, 570, 670, 770, 870, L2) disposed on the etch stop layer (160, 260, 360, 460, 560, 660, 760, 860, L1);
a plurality of connection lines (130, 230, 330, 430, 530, 630, 730, 830, ES) disposed on the planarization layer (170, 270, 370, 470, 570, 670, 770, 870); and
a first blocking pattern (125, 225, 325, 425, 525, 625, 725, 825, SD) overlapping with at least one connection line of the plurality of connection lines (130, 230, 330, 430, 530, 630, 730, 830, ES), the first blocking pattern (125, 225, 325, 425, 525, 625, 725, 825, SD) being disposed between the etch stop layer (160, 260, 360, 460, 560, 660, 760, 860, L1) and the planarization layer (170, 270, 370, 470, 570, 670, 770, 870, L2).

2. The display device of claim 1, further comprising a bank (180, 280, 380, 480, 580, 680, 780, 880) disposed on the planarization layer (170, 270, 370, 470, 570, 670, 770, 870).

3. The display device of claim 1 or 2, wherein at least one of the etch stop layer (360), the planarization layer (370, 470, 670) and the bank (480, 580, 680, 880) includes a trench (TC1, TC2, TC3, TC4, TC5) disposed in a region between the plurality of connection lines (330, 430, 530, 630, 830).

4. The display device of claim 3, wherein the trench formed in the bank (480, 580, 680, 880) overlaps the trench formed in the planarization layer (370, 470, 670) and/or the etch stop layer (360).

5. The display device of claim 3 or 4, wherein the trench is formed to be continuous in the etch stop layer (360) and the planarization layer (370) or the planarization layer (470, 670) and the bank (480, 680); or wherein the trench is only formed in the planarization layer (370) or in the bank (580, 880).

6. The display device of any of the preceding claims, wherein the first blocking pattern (125, 225, 325, 425, 525, 625, 725, 825, SD) includes a metal, and
wherein the etch stop layer (160, 260, 360, 460, 560, 660, 760, 860, L1) includes an organic insulating material.

7. The display device of any of the preceding claims, further comprising:
a coating layer (101, 201) disposed between the first substrate (11, 110, SUB1) and the second substrate (12, 120, SUB2), the coating layer (101, 201) overlapping with a portion of the etch stop layer (160, 260, 360, 460, 560, 660, 760, 860, L1).

8. The display device of claim 7, further comprising a second blocking pattern (515, 615, 815a) disposed between the etch stop layer (560, 660, 860) and the coating layer (101),
wherein the second blocking pattern (515, 615, 815a) is disposed in a region between the plurality of connection lines (530, 630, 830).

9. The display device of any one of the preceding claims, further comprising a first electrode (91) corresponding at least one of the plurality of subpixels (PXL),
wherein the plurality of connection lines (130, 230, 330, 430, 530, 630, 730, 830, ES) are disposed on a same layer as the first electrode (91).

10. The display device of claim 9, further comprising:
at least one transistor (Tr) disposed on the first substrate (11) and corresponding to the first electrode (91); and
a first connection electrode (61) that electrically connects the first electrode (91) with a drain electrode (53) of the at least one transistor (Tr),
wherein the first blocking pattern (125, 225, 325, 425, 525, 625, 725, 825, SD) is disposed on a same layer as the first connection electrode (61).

11. The display device of claim 10, further comprising a first pad layer (20) disposed on a same layer as a source electrode (51) or the drain electrode (53) of the at least one transistor (Tr) and electrically connected to at least one of the plurality of connection lines (130, 230, 330, 430, 530, 630, 730, 830, ES),
wherein, when dependent on claim 8, the second blocking pattern (515, 615, 815a) is disposed on the same layer as the first pad layer (20).

12. The display device of claim 7, wherein the coating layer (201) includes:
a first surface (S1) in contact with each of the first substrate (110) and the second substrate (120); and
a second surface (S2) that is formed at an angle with respect to the first surface (S1), and
wherein the second surface (S2) of the coating layer (201) is bent or curved from a surface plane in which a flat upper surface of the first substrate (110) and the second substrate (120) are each in contact with the etch stop layer (760).

13. The display device of claim 12, wherein the coating layer (201) includes a convex portion (PT) protruding in a direction toward the etch stop layer (760).

14. The display device of any of the preceding claims, wherein the first blocking pattern (125, 225, 325, 425, 525, 625, 725, 825, SD) includes:
a first layer (125a) adjacent to the first substrate (110) and the second substrate (120); and
a plurality of layers (125b) on the first layer (125a), and
wherein the first layer (125a) of the first blocking pattern (125, 225, 325, 425, 525, 625, 725, 825, SD) has higher chemical resistance to an etchant than the plurality of layers (125b); and/or wherein the first layer (125a) is convex in a direction toward the etch stop layer (160).

15. The display device of any of the preceding claims, wherein the plurality of connection lines (130, 230, 330, 430, 530, 630, 730, 830, ES) include:
a first layer adjacent to the first substrate (110) and the second substrate (120); and
a plurality of layers on the first layer, and
wherein the first layer of the plurality of connection lines (130, 230, 330, 430, 530, 630, 730, 830, ES) has higher chemical resistance to an etchant than the plurality of layers.
